(19) Europäisches Patentamt
European Patent Office
Office européen des brevets

(11) **EP 2 518 190 A1**

(12) **EUROPEAN PATENT APPLICATION**
published in accordance with Art. 153(4) EPC

(43) Date of publication:
**31.10.2012 Bulletin 2012/44**

(51) Int Cl.:
**C25D 11/04** (2006.01)  **H01L 33/62** (2010.01)

(21) Application number: **10839243.2**

(22) Date of filing: **14.12.2010**

(86) International application number:
**PCT/JP2010/072463**

(87) International publication number:
**WO 2011/078010 (30.06.2011 Gazette 2011/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.12.2009 JP 2009295050**
**20.01.2010 JP 2010009826**
**26.02.2010 JP 2010042287**
**19.03.2010 JP 2010064186**
**21.04.2010 JP 2010097856**

(71) Applicant: **FUJIFILM Corporation**
**Tokyo 106-0031 (JP)**

(72) Inventors:
• **HATANAKA, Yusuke**
**Haibara-gun**
**Shizuoka 421-0396 (JP)**
• **HOTTA, Yoshinori**
**Haibara-gun**
**Shizuoka 421-0396 (JP)**
• **UESUGI, Akio**
**Haibara-gun**
**Shizuoka 421-0396 (JP)**

(74) Representative: **HOFFMANN EITLE**
**Patent- und Rechtsanwälte**
**Arabellastrasse 4**
**81925 München (DE)**

(54) **INSULATED SUBSTRATE, PROCESS FOR PRODUCTION OF INSULATED SUBSTRATE, PROCESS FOR FORMATION OF WIRING LINE, WIRING SUBSTRATE, AND LIGHT-EMITTING ELEMENT**

(57) Provided is an insulating substrate which includes an aluminum substrate and an anodized film covering a whole surface of the aluminum substrate and in which the anodized film contains intermetallic compound particles with a circle equivalent diameter of 1 $\mu$m or more in an amount of up to 2,000 pcs/mm$^3$. Also provided is a method for manufacturing the insulating substrate which includes an anodizing treatment step for anodizing the aluminum substrate. The anodized film of the insulating substrate covering the whole surface of the aluminum substrate contains intermetallic compound particles with a circle equivalent diameter of 1 $\mu$m or more in an amount of up to 2,000 pcs/mm$^3$.

**Description**

TECHNICAL FIELD

The present invention relates to an insulating substrate that may be used in light-emitting devices and more specifically to an insulating substrate that may be used in light-emitting diodes (hereinafter referred to as "LEDs").

BACKGROUND ART

It is said that LEDs generally use as little as one-hundredth of the electricity consumed in fluorescent lamps and have a lifetime forty times longer than that of fluorescent lamps (40,000 hours). The characteristics including power saving and longer lifetime are important elements based on which LEDs are adopted in the environment-oriented society. In particular, white LEDs also have merits including excellent color rendering properties and simpler power circuit than fluorescent lamps and therefore expectations are rising for their use in illumination light sources.
Recently, white LEDs with high luminous efficiency (30 to 150 Lm/W) required for the illumination light source successively appeared on the market and replace fluorescent lamps (20 to 110 Lm/W) in terms of the light use efficiency during practical use.
This sharply accelerated the trend for practical application of white LEDs instead of fluorescent lamps and there are an increasing number of cases where white LEDs are adopted for the backlight and illumination light source in liquid crystal display devices.
In the meantime, the following problem is pointed out: A large amount of current passing through an LED chip to achieve higher luminance increases the amount of heat generation to promote deterioration over time of a phosphor-bearing resin material for use in wavelength conversion, consequently compromising the feature of long lifetime.
In fact, in conventional LEDs, as a result of prolonged driving or high-current driving for increasing the light-emission luminance, LED chips significantly generate heat to be rendered at high temperature, thus causing heat deterioration.
In order to solve such problems, insulating substrates formed by coating the surface of an aluminum substrate with an anodized film have been proposed (see, for example, Patent Literatures 1 to 8). In these cases, the anodized film has insulation properties and the aluminum substrate has high heat conductivity and therefore good heat dissipation properties are achieved.
LED light-emitting devices illuminating monitors that perform color display using RGB color filters have been heretofore commonly known as white LED light-emitting devices. Of these, multi-color mixed type LED light-emitting devices are used.
In such multi-color mixed type LED light-emitting devices, simultaneous light emission from LEDs of RGB three colors causes emission of white light and the white light is combined with a color filter of a monitor to perform color display.
However, in the multi-color mixed type LED light-emitting devices, each of the RGB LEDs emits light and therefore has high color purity and excellent color rendering properties but a large number of LEDs are required in order to obtain white light, thus increasing the cost.
For example, phosphor color mixed type LED light-emitting devices such as those described in Patent Literatures 1 and 2 are known as LED light-emitting devices to solve this problem.

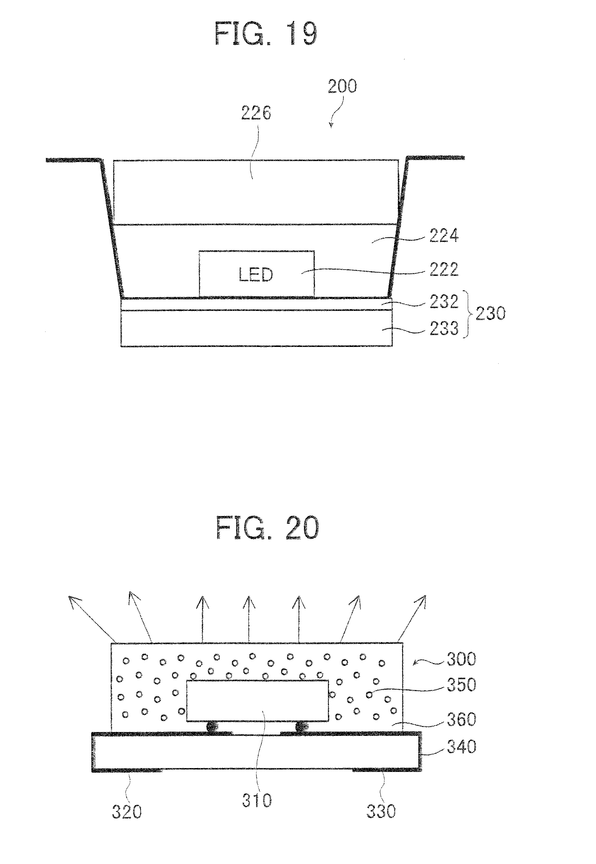

FIG. 20 is a schematic view illustrating the configuration of an example of a phosphor color mixed type, white LED light-emitting device as disclosed in Patent Literatures 9 and 10. As shown in FIG. 20, in a white LED light-emitting device 300, a blue LED 310 is molded with a transparent resin 360 containing YAG phosphor particles 350, and light excited by the YAG phosphor particles 350 is combined with afterglow of the blue LED 310 to emit white light. The blue LED 310 is mounted by face-down bonding on a substrate 340 having electrodes 320, 330 for external connection.
In such conventionally known phosphor color mixed type LED light-emitting devices, for example, a process in which the thickness of a transparent resin containing phosphor particles is increased, and a process in which the content of phosphor particles in a transparent resin is increased have been studied to increase the white light emission power.
In such conventionally known phosphor color mixed type LED light-emitting devices, a metal substrate having an aluminum oxide film formed by anodization on the surface of an aluminum substrate is known as a substrate for which the heat dissipation properties and the insulation properties are taken into account (see Patent Literature 11).

CITATION LIST

PATENT LITERATURE

Patent Literature 1: JP 2007-250315 A
Patent Literature 2: JP 55-154564 U
Patent Literature 3: JP 2006-344978 A
Patent Literature 4: JP 7-14938 A
Patent Literature 5: JP 2006-244828 A
Patent Literature 6: JP 2009-164583 A
Patent Literature 7: JP 11-504387 A
Patent Literature 8: JP 6-45515 A
Patent Literature 9: JP 2998696 B
Patent Literature 10: JP 11-87784 A
Patent Literature 11: JP 6-45515 A

SUMMARY OF INVENTION

TECHNICAL PROBLEMS

The inventors of the invention have further studied the insulating substrates described in Patent Literatures 1 to 8. As a result, it was revealed that good insulation properties cannot be obtained depending on the conditions of anodizing treatment for obtaining an anodized film and the aluminum substrate used.

An increase in the thickness of the anodized film to improve the insulation properties (withstand voltage) clearly reduces the heat dissipation properties, and it was revealed that excellent insulation properties and heat dissipation properties are difficult to achieve simultaneously.

In cases where a process involving an increase in the thickness of a transparent resin containing phosphor particles, a process involving an increase in the content of phosphor particles in a transparent resin or other process is applied to increase the white light emission power in the conventionally known phosphor color mixed type LED light-emitting devices as disclosed in Patent Literatures 9 and 10, the permeability of blue light from the blue LED may be reduced to lower the white light emission power depending on the thickness of the transparent resin or the content of the phosphor particles in the transparent resin.

The metal substrate described in Patent Literature 11 does not have sufficient insulation properties and the leakage current from the metal interconnection which is connected to the mounted LED may be leaked to the metal substrate through the anodized layer, thus causing short circuit.

A first object of the invention is to provide an insulating substrate capable of obtaining good insulation properties while maintaining excellent heat dissipation properties.

A second object of the invention is to provide an insulating substrate capable of providing a light-emitting device having excellent insulation properties and heat dissipation properties and its manufacturing method, and the light-emitting device using the same.

A third object of the invention is to provide an insulating substrate capable of providing a light-emitting device having excellent insulation properties and heat dissipation properties and improved white light emission power, and the light-emitting device using the same.

SOLUTION TO PROBLEMS

The inventors of the invention have made an intensive study to achieve the first object and as a result found that good insulation properties are obtained when an anodized film contains intermetallic compound particles with a circle equivalent diameter of 1 $\mu$m or more in an amount of up to 2,000 pcs/mm$^3$. The invention (first aspect) has been thus completed.

The inventors of the invention have also made an intensive study to achieve the second object and as a result found that excellent insulation properties and heat dissipation properties can be simultaneously achieved using an insulating substrate which has an insulation layer obtained by adjusting the porosity of the anodized film to a predetermined value or less. The invention (second aspect) has been thus completed.

The inventors of the invention have further made an intensive study to achieve the third object and as a result found that, by using an insulating substrate in which the thickness of the whole insulating substrate and the thickness of the insulation layer in the insulating substrate as well as the ratio therebetween are adjusted within predetermined ranges, and the depth of micropores in the insulation layer is adjusted within a predetermined range, a good balance can be achieved between the insulation properties and the heat dissipation properties while improving the white light emission power. The invention (third aspect) has been thus completed.

Specifically, the invention provides the following (1) to (35).

(1) An insulating substrate comprising: an aluminum substrate and an anodized film covering a whole surface of the aluminum substrate, wherein the anodized film contains intermetallic compound particles with a circle equivalent diameter of 1 $\mu$m or more in an amount of up to 2,000 pcs/mm$^3$.

(2) The insulating substrate according to (1) further comprising through-holes formed so as to extend through the aluminum substrate in its thickness direction, wherein inner wall surfaces of the through-holes are covered with the anodized film.

(3) The insulating substrate according to (1) or (2), wherein the aluminum substrate has an aluminum purity of 99.95 wt% or more.

(4) The insulating substrate according to any one of (1) to (3), wherein the insulating substrate is for use in an LED.

(5) An insulating substrate-manufacturing method for obtaining the insulating substrate according to (1), comprising: an anodizing treatment step for anodizing the aluminum substrate, wherein the anodized film covering the whole surface of the aluminum substrate contains intermetallic compound particles with a circle equivalent diameter of 1 $\mu$m or more in an amount of up to 2,000 pcs/mm$^3$.

(6) The insulating substrate-manufacturing method according to (5) for obtaining the insulating substrate according to (2), comprising, before the anodizing treatment step, a through-hole formation step for forming the through-holes in the thickness direction of the aluminum substrate.

(7) The insulating substrate-manufacturing method according to (5) or (6), comprising, before the anodizing treatment step, an annealing treatment step for annealing the aluminum substrate at 350 to 600°C.

(8) The insulating substrate-manufacturing method according to any one of (5) to (7), wherein a sulfuric acid electrolytic solution is used in the anodizing treatment step.

(9) The insulating substrate-manufacturing method according to (8), wherein the sulfuric acid electrolytic solution has a sulfuric acid concentration of 10 to 60 g/l.

(10) The insulating substrate-manufacturing method according to any one of (5) to (9), wherein the aluminum substrate has an aluminum purity of 99.95 wt% or more.

(11) An interconnection-forming method for forming interconnections in desired portions on the anodized film included in the insulating substrate according to any one of (1) to (3), the method comprising: a supply step for selectively supplying conductor metal serving as the interconnections only to the desired portions.

(12) The interconnection-forming method according to (11), wherein the supply step is a step for supplying metal ink containing the conductor metal to the desired portions by ink-jet printing.

(13) The interconnection-forming method according to (11), wherein the supply step is a step for supplying metal ink containing the conductor metal to the desired portions by screen printing.

(14) The interconnection-forming method according to (11), wherein the supply step is a step in which a treatment solution containing ions of the conductor metal is used to perform electroless plating and/or electrolytic plating on the insulating substrate having a resist formed in portions other than the desired portions on the anodized film.

(15) The interconnection-forming method according to (11), wherein the supply step is a step including forming a metal-reducing layer having metal-reducing ability in the desired portions and bringing the formed metal-reducing layer into contact with a treatment solution containing ions of the conductor metal.

(16) The interconnection-forming method according to any one of (11) to (15), wherein the desired portions are located on front and back sides of the insulating substrate.

(17) An insulating substrate comprising:

a metal substrate and an insulation layer formed at a surface of the metal substrate,
wherein the metal substrate is a valve metal substrate,
wherein the insulation layer comprises an anodized film of a valve metal, and
wherein the anodized film has a porosity of 30% or less.

(18) The insulating substrate according to (17), wherein the anodized film has surface topographic features with an average diameter of at least 1 $\mu$m at an average pitch of up to 0.5 $\mu$m.

(19) The insulating substrate according to (17) or (18), wherein the anodized film has micropores, and wherein at least part of an interior of each of the micropores is sealed with a different substance from a substance making up the anodized film.

(20) The insulating substrate according to any one of (17) to (19), wherein the anodized film has micropores, and wherein the micropores include micropores each having an interior at least partly sealed with a different substance from a substance making up the anodized film, and micropores each having an interior unsealed with the different substance.

(21) The insulating substrate according to (19) or (20), wherein the different substance has insulation properties.

(22) The insulating substrate according to any one of (17) to (21), wherein the valve metal is at least one metal selected from the group consisting of aluminum, tantalum, niobium, titanium, hafnium, zirconium, zinc, tungsten, bismuth and antimony.

(23) The insulating substrate according to (22), wherein the valve metal is aluminum.

(24) The insulating substrate according to any one of (17) to (23), wherein the insulating substrate is a substrate provided on a light emission observation surface side of an LED light-emitting device.

(25) An insulating substrate-manufacturing method for manufacturing the insulating substrate according to any one of (17) to (24), the method comprising:

> an anodizing treatment step for anodizing a surface of the valve metal substrate to form the anodized film of the valve metal on the valve metal substrate; and
>
> a sealing treatment step for sealing after the anodizing treatment step to adjust the porosity of the anodized film to 30% or less.

(26) The insulating substrate-manufacturing method according to (25),
wherein the anodized film having the micropores is formed by the anodizing treatment, and
wherein at least part of the interior of each of the micropores is sealed with the different substance from the substance making up the anodized film by the sealing treatment.

(27) The insulating substrate-manufacturing method according to (25) or (26), comprising a through-hole formation step for forming through-holes in a thickness direction of the valve metal substrate.

(28) The insulating substrate-manufacturing method according to (27), comprising, after the through-hole formation step, a chip formation step for enabling the valve metal substrate to be divided into individual chips having a desired shape.

(29) An interconnection substrate comprising: the insulating substrate according to any one of (17) to (24) and a metal interconnection layer provided on top of the insulating substrate on an insulation layer side.

(30) A white LED light-emitting device comprising: the interconnection substrate according to (29); a blue LED light-emitting device provided on top of the interconnection substrate on a metal interconnection layer side; and a fluorescent emitter provided at least on top of the blue LED light-emitting device.

(31) An insulating substrate comprising:

> an aluminum substrate and an insulation layer formed at a surface of the aluminum substrate,
> wherein the insulation layer comprises an aluminum anodized film having micropores,
> wherein the insulating substrate has a thickness of up to 1,500 $\mu$m,
> wherein the anodized film has a thickness of at least 5 $\mu$m,
> wherein a ratio ($T_A/T_O$) of the thickness ($T_A$) of the insulating substrate to the thickness ($T_O$) of the anodized film is from 2.5 to 300, and
> wherein, of thicknesses of the anodized film in its depth direction, a thickness of a portion where no micropore is formed is at least 30 nm.

(32) The insulating substrate according to (31), wherein a degree of ordering of the micropores as defined by formula (i):

$$\texttt{Degree of ordering (\%) = B/A} \times \texttt{100 (i)}$$

(in formula (i), A represents a total number of micropores in a measurement region, and B represents a number of specific micropores in the measurement region for which, when a circle is drawn so as to be centered on a center of gravity of a specific micropore and so as to be of a smallest radius that is internally tangent to an edge of another micropore, the circle includes centers of gravity of six micropores other than the specific micropore) is 20% or more.

(33) The insulating substrate according to (31) or (32), wherein the insulating substrate is a substrate provided on a light emission observation surface side of an LED light-emitting device.

(34) An insulating substrate-manufacturing method for manufacturing the insulating substrate according to any one of (31) to (33), the method comprising:

> a first anodizing treatment step for anodizing part of the aluminum substrate to form the aluminum anodized film having the micropores on the aluminum substrate; and
>
> a second anodizing treatment step which follows the first anodizing treatment step and in which an electrolytic solution at a pH of 2.5 to 11.5 is used to carry out anodizing treatment to seal part of an interior of each of the micropores with aluminum oxide from a bottom direction.

(35) A white LED light-emitting device comprising: the insulating substrate according to any one of (31) to (33); a blue LED light-emitting device provided on top of the insulating substrate on an insulation layer side; and a fluorescent emitter provided at least on top of the blue LED light-emitting device.

ADVANTAGEOUS EFFECTS OF INVENTION

The invention can provide an insulating substrate capable of obtaining good insulation properties while maintaining excellent heat dissipation properties.

The invention can also provide an insulating substrate capable of providing a light-emitting device having excellent insulation properties and heat dissipation properties and its manufacturing method, and the light-emitting device using the same.

The invention can further provide an insulating substrate capable of providing a light-emitting device having excellent insulation properties and heat dissipation properties and improved white light emission power, and the light-emitting dvice using the same.

BRIEF DESCRIPTION OF DRAWINGS

[FIG. 1] FIG. 1 shows schematic views illustrating a preferred embodiment of an insulating substrate of the invention, (A) being a plan view and (B) being a cross-sectional view.

[FIG. 2] FIG. 2 is a flowchart illustrating a preferred embodiment of the insulating substrate of the invention.

[FIG. 3] FIG. 3 shows schematic views illustrating the insulating substrate in Comparative Example I-1, (A) being a plan view and (B) being a cross-sectional view.

[FIG. 4] FIG. 4 shows schematic views illustrating the state in the continuity test, (A) being a plan view and (B) being a cross-sectional view.

[FIG. 5] FIG. 5 is a schematic view for illustrating routing.

[FIG. 6] FIG. 6 is a schematic cross-sectional view illustrating a preferable example of the routing in the invention.

[FIG. 7] FIG. 7 is a schematic cross-sectional view illustrating an example of the routing.

[FIG. 8] FIG. 8 shows schematic cross-sectional views for illustrating interconnection in the insulating substrate.

[FIG. 9] FIG. 9 shows schematic views for illustrating supply of conductor metal.

[FIG. 10] FIG. 10 shows schematic views illustrating an interconnection pattern, (A) being a plan view and (B) being a bottom view.

[FIG. 11] FIG. 11 shows schematic cross-sectional views illustrating an embodiment in which micropores are sealed with a different substance.

[FIG. 12] FIG. 12 is a schematic view of an anodizing apparatus that may be used to perform anodizing treatment in the manufacture of the insulating substrate of the invention.

[FIG. 13] FIG. 13 is a schematic cross-sectional view illustrating the configuration of an example of a white LED light-emitting device of the invention.

[FIG. 14] FIG. 14 is a schematic cross-sectional view illustrating the configuration of another example of the white LED light-emitting device of the invention.

[FIG. 15] FIG. 15 is a schematic cross-sectional view illustrating the configuration of another example of the white LED light-emitting device of the invention.

[FIG. 16] FIG. 16 is a schematic view illustrating a preferred embodiment of the insulating substrate of the invention.

[FIG. 17] FIG. 17 illustrates a method for computing the degree of ordering of micropores.

[FIG. 18] FIG. 18 is a diagram for illustrating, in the insulating substrate of the invention, the thickness ($T_A$) of the insulating substrate, the thickness (To) of an anodized film and the thickness ($T_F$) of the anodized film in the portion having no micropore formed therein.

[FIG. 19] FIG. 19 is a schematic cross-sectional view illustrating the configuration of an example of the white LED light-emitting device of the invention.

[FIG. 20] FIG. 20 is a schematic cross-sectional view illustrating the configuration of an example of a conventional phosphor color mixed type, white LED light emitting device.

DESCRIPTION OF EMBODIMENTS

1. First Aspect

[Insulating Substrate]

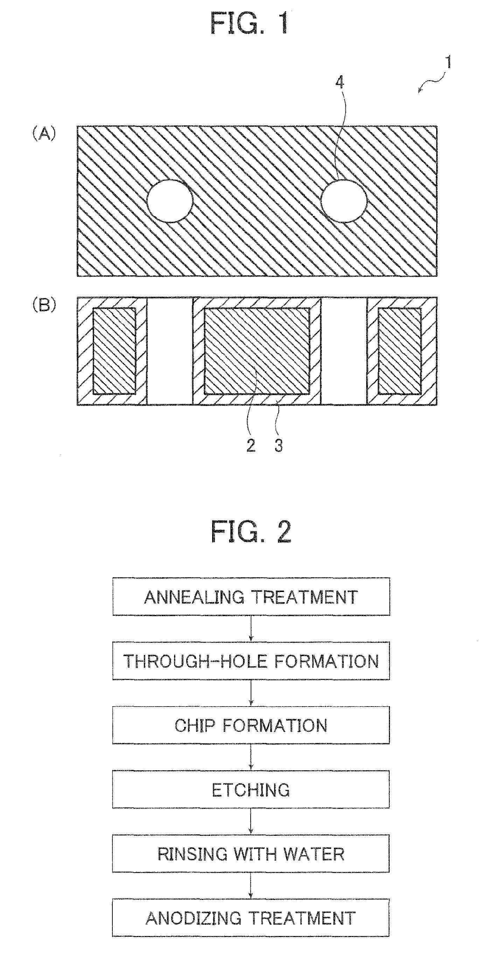

The insulating substrate of the invention is described below in detail.
The insulating substrate of the invention includes an aluminum substrate and an anodized film covering the whole surface of the aluminum substrate and the anodized film contains intermetallic compound particles with a circle equivalent diameter of 1 $\mu$m or more in an amount of up to 2,000 pcs/mm$^3$.
Next, the structure of the insulating substrate of the invention is described with reference to FIG. 1.
FIG. 1 shows schematic views illustrating a preferred embodiment of the insulating substrate of the invention, (A) being a plan view and (B) being a cross-sectional view.
As shown in FIG. 1, an insulating substrate 1 of the invention consists primarily of an aluminum substrate 2. The whole surface of the aluminum substrate 2 is covered with an anodized film 3.
The "whole surface" of the aluminum substrate 2 as used herein encompasses all the exposed surfaces of the aluminum substrate 2 contacting the external atmosphere, and is a concept including not only the front and back surfaces of the aluminum substrate 2 but also the surfaces defining the thickness of the aluminum substrate when the aluminum substrate 2 is in plate form as shown in FIG. 1.
As shown in FIG. 1, the aluminum substrate 2 may be perforated in its thickness direction with through-holes 4. The whole surface of the aluminum substrate 2 is covered with the anodized film 3 and therefore the inner wall surfaces of the through-holes 4 are also covered with the anodized film 3.
In the insulating substrate 1 of the invention, the anodized film 3 serves as the insulation layer. Therefore, an interconnection for power supply (not shown) can be formed from the back surface side of the insulating substrate 1 along the anodized film 3 on the periphery of the insulating substrate 1 with respect to an LED chip (not shown) to be disposed on the front surface of the insulating substrate 1.
Since the inner wall surfaces of the through-holes 4 are also covered with the anodized film 3, the interconnection may also be formed from the back surface side of the insulating substrate 1 through the through-holes 4 toward the front surface side of the insulating substrate 1.
When an LED chip is to be mounted on the surface of the insulating substrate, it is necessary to form the interconnection for power supply from the back surface side toward the front surface side of the insulating substrate, and the insulating substrate 1 of the invention enables such formation.
As will be described later, the interconnection may be formed by, for example, a method which involves printing and baking of metal ink through ink-jet printing or screen printing.
The aluminum substrate 2 has high heat conductivity in this process and therefore excellent heat dissipation properties are obtained even if the LED chip is heated.
The aluminum substrate, the anodized film, the through-holes and the like making up the insulating substrate of the invention are described below in detail.

[Aluminum Substrate]

Any known aluminum substrate may be used for the aluminum substrate and illustrative examples of the substrate that may be used include pure aluminum substrates; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered with high-purity aluminum by a process such as vapor deposition or sputtering; and resin substrates on which aluminum has been laminated.
The thickness of the aluminum substrate is not particularly limited and is preferably from 0.2 to 0.5 mm in terms of reducing the height of the mounted portion. Flexible response to design changes is also possible by forming the aluminum substrate 2 into a desired shape.
The aluminum substrate preferably has a higher aluminum purity. More specifically, the aluminum purity is preferably at least 99.95 wt% and more preferably at least 99.99 wt%.
At an aluminum purity within the foregoing range, impurities such as Si and Fe in the aluminum substrate are reduced to extremely small amounts and the number of intermetallic compound particles remaining in the anodized film formed by anodizing treatment to be described later is reduced.
The surface of the aluminum substrate on which anodizing treatment to be described later is to be carried out is preferably subjected beforehand to degreasing treatment and mirror-like finishing treatment.
Degreasing treatment is carried out with a suitable substance such as an acid, alkali or organic solvent so as to dissolve and remove organic substances, including dust, grease and resins, adhering to the aluminum substrate. Known degreasers may be used in degreasing treatment. More specifically, degreasing treatment may be carried out, for example, using any of various commercially available degreasers by the prescribed method.

Mirror-like finishing treatment is carried out to eliminate surface topographic features of the aluminum substrate (e.g., rolling streaks formed during rolling of the aluminum substrate). Mirror-like finishing treatment is not subject to any particular limitation, and may be carried out using any suitable method known in the art. Examples of suitable methods include mechanical polishing, chemical polishing, and electrolytic polishing.

[Anodized Film]

The anodized film is an aluminum oxide film containing intermetallic compound particles with a circle equivalent diameter of 1 $\mu$m or more in an amount of up to 2,000 pcs/mm$^3$.

The anodized film is formed on the whole surface of the aluminum substrate by subjecting the aluminum substrate to, for example, anodizing treatment to be described later.

The anodized film preferably has a thickness of 5 to 75 $\mu$m and more preferably 10 to 50 $\mu$m in terms of the insulation properties.

The intermetallic compounds are described below.

The intermetallic compounds as used in the invention refer to compounds made up of aluminum in the aluminum substrate and impurities such as Si and Fe. It is said that anodizing treatment to be described later oxidizes part of the intermetallic compounds together with aluminum, whereas another part of the intermetallic compounds remain unchanged.

In the practice of the invention, the anodized film contains intermetallic compound particles with a circle equivalent diameter of 1 $\mu$m or more in an amount of up to 2,000 pcs/mm$^3$, preferably up to 1,000 pcs/mm$^3$, more preferably up to 800 pcs/mm$^3$ and even more preferably up to 200 pcs/mm$^3$.

The number of intermetallic compound particles was measured as follows: First, the outer surface and the cross-sectional surface of the anodized film were observed by FE-SEM (S-4000 manufactured by Hitachi, Ltd.) at an observation magnification of 10,000X at an acceleration voltage of 2 kV in a plurality of fields of view so that the measured area may be 0.01 mm$^2$. The existence probability Ps (pcs/mm$^2$) of the intermetallic compound particles at the outer surface of the anodized film and the existence probability Pc (pcs/mm$^2$) of the intermetallic compound particles at the cross-sectional surface of the anodized film were determined from the observation results and the number of intermetallic compound particles in the anodized film was arithmetically determined from the calculation formula $\{(Ps \times Pc)^{(3/4)}\}$ to two significant figures.

The circle equivalent diameter is a value calculated as the diameter of a circle having the same area as that of the intermetallic compound particle in the SEM image.

When the number of intermetallic compound particles in the anodized film is within the foregoing range, the insulating substrate of the invention has excellent insulation properties.

This is presumably because the intermetallic compound particles remaining in the anodized film are considered to induce breakdown or other defect but according to the invention, the absolute number of the intermetallic compound particles in the anodized film is reduced to a low level and therefore breakdown or other defect is less likely to occur.

The inventors of the invention revealed that intermetallic compound particles increase in the core portion of the aluminum substrate. This is presumably due to the aluminum casting step.

Therefore, in the case of forming the anodized film also at the surface of the core portion of the aluminum substrate, it is deemed that a difference occurs in the number of intermetallic compound particles between this anodized film and the anodized film formed at another position and a difference is likely to occur also in the properties such as the insulation properties.

In the invention, however, the number of intermetallic compound particles is reduced as a whole and therefore it is deemed that a difference is also unlikely to occur in the properties such as the insulation properties due to the difference in the position of the anodized film formed.

[Through-Holes]

The through-holes are formed as desired by perforating the aluminum substrate in its thickness direction before the anodized film is formed by anodizing treatment to be described later. In this way, the inner wall surfaces of the through-holes are also coated with the anodized film.

The shape of the through-holes is not particularly limited but the through-holes are preferably formed so as to have a slightly larger diameter than the hole diameter to be obtained, in consideration of the volume expansion of the aluminum substrate during anodizing treatment to be described later.

The number of through-holes formed is changed from embodiment to embodiment and is therefore not particularly limited. For example, each of smaller pieces into which the aluminum substrate is cut has two through-holes.

[Insulating Substrate-Manufacturing Method]

The method of manufacturing the insulating substrate according to the invention is described below in detail. The insulating substrate-manufacturing method of the invention is the one for obtaining the above-described insulating substrate of the invention and is the one which includes an anodizing treatment step for anodizing the aluminum substrate and with which the above-described insulating substrate of the invention is obtained.

Next, the steps of the method of manufacturing the insulating substrate of the invention are described with reference to FIG. 2. FIG. 2 is a flowchart illustrating a preferred embodiment of the insulating substrate of the invention.

[Anodizing Treatment Step]

The anodizing treatment step is a step for anodizing the aluminum substrate to form the anodized film covering the whole surface of the aluminum substrate.

Anodizing treatment in the anodizing treatment step can be performed by a conventional method used in the manufacture of a lithographic printing plate support.

More specifically, sulfuric acid, phosphoric acid, chromic acid, oxalic acid, sulfamic acid, benzenesulfonic acid, amidosulfonic acid, malonic acid, citric acid, tartaric acid and boric acid may be used alone or in combination of two or more for the solution for use in anodizing treatment. Of these, sulfuric acid and boric acid are preferably used.

In the case of using a sulfuric acid electrolytic solution, the sulfuric acid concentration is preferably from 10 to 60 g/l and more preferably from 20 to 40 g/l. At a sulfuric acid concentration within the foregoing range, the number of intermetallic compound particles remaining in the anodized film is reduced and therefore the insulating substrate of the invention has more excellent insulation properties.

It is acceptable for at least ingredients ordinarily present in the aluminum substrate, electrodes, tap water, groundwater and the like to be present in the electrolytic solution. In addition, secondary and tertiary ingredients may be added. Here, "secondary and tertiary ingredients" include, for example, the ions of metals such as Na, K, Mg, Li, Ca, Ti, Al, V, Cr, Mn, Fe, Co, Ni, Cu and Zn; cations such as ammonium ion; and anions such as nitrate ion, carbonate ion, chloride ion, phosphate ion, fluoride ion, sulfite ion, titanate ion, silicate ion and borate ion. These may be present in concentrations of about 0 to 10,000 ppm.

The anodizing treatment conditions in the anodizing treatment step vary depending on the electrolytic solution used and thus cannot be strictly specified. However, it is generally suitable for the solution to have an electrolyte concentration of 1 to 80 wt% and a temperature of 5 to 70°C, and for the current density to be 0.5 to 60 A/dm$^2$, the voltage to be 1 to 100 V, and the electrolysis time to be 15 seconds to 50 minutes. These conditions may be adjusted to obtain the desired anodized film weight.

When anodizing treatment is carried out in the sulfuric acid-containing electrolytic solution in the anodizing treatment step, direct current or alternating current may be applied across the aluminum substrate and the counter electrode.

When a direct current is applied to the aluminum substrate, the current density is preferably from 1 to 60 A/dm$^2$, and more preferably from 5 to 40 A/dm$^2$.

To keep burnt deposits from arising on portions of the aluminum substrate due to the concentration of current when anodizing treatment in the anodizing treatment step is carried out as a continuous process, it is preferable to apply current at a low current density of 5 to 10 A/dm$^2$ at the start of anodizing treatment and to increase the current density to 30 to 50 A/dm$^2$ or more as anodizing treatment proceeds. When anodizing treatment is carried out as a continuous process, this is preferably done using a system that supplies power to the aluminum substrate through the electrolytic solution.

Anodizing treatment in the anodizing treatment step may be performed under a single treatment condition but anodizing treatments under two or more different conditions may be performed in combination.

For example, anodizing treatment using a sulfuric acid electrolytic solution may be followed by anodizing treatment using an electrolytic solution containing boric acid and sodium borate (additional treatment with boric acid). The number of intermetallic compound particles in the anodized film is thus further reduced in the resulting insulating substrate. The conditions of the additional treatment with boric acid are not particularly limited and the boric acid concentration is preferably from 0.1 to 1 M and more preferably from 0.3 to 0.6 M. The sodium borate concentration is preferably from 0.01 to 0.1 M and more preferably from 0.03 to 0.06 M. In addition, the voltage is preferably from 200 to 600 V and the solution temperature is preferably from 20 to 60°C.

[Through-Hole Formation Step]

The insulating substrate-manufacturing method of the invention may include a through-hole formation step. The through-hole formation step is a step in which the aluminum substrate is perforated in its thickness direction with through-holes before the anodizing treatment step is carried out.

Conventionally known methods may be applied in the through-hole formation and, for example, drilling, laser processing and punching using a die may be used.

As described above, the through-holes are preferably formed so as to have a slightly larger diameter than the hole diameter to be obtained, in consideration of the volume expansion of the aluminum substrate during anodizing treatment.

[Chip Formation Step]

The insulating substrate-manufacturing method of the invention may include a chip formation step. The chip formation step is a step in which the aluminum substrate is divided into chips having a desired shape before the anodizing treatment step (if the through-hole formation step is included, after the through-hole formation step or simultaneously with the through-hole formation step). In this step, conventionally known methods may be applied and, for example, punching using a die, and routing using a drill or a laser may be used.

<Routing>

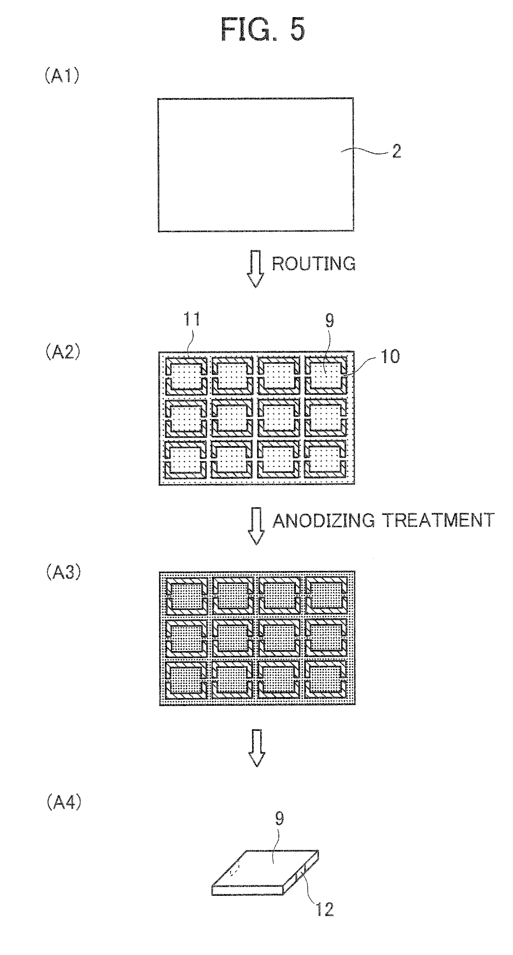

Routing is described below with reference to FIG. 5. Routing is carried out to obtain the aluminum substrate in the form of chips 9 (see FIG. 5 (A2)) from the aluminum substrate 2 in plate form (see FIG. 5 (AI).

In routing, cutout portions 11 penetrating through the aluminum substrate 2 are formed on the peripheries of the chips 9 (see FIG. 5 (A2)). Joint portions 10 connecting the chips 9 with each other or with the aluminum substrate 2 are preferably left connected because the chips 9 are not separated from the aluminum substrate 2 and can be treated as members integrated with the aluminum substrate 2.

The chips 9 which serve as the insulating substrates are obtained (see FIG. 5 (A4)) by carrying out the above-described anodizing treatment (see FIG. 5 (A3)) after routing and cutting the joint portions 10.

Cut edges 12 which are non-anodized aluminum portions emerge at the lateral surfaces of the chips 9 after cutting of the joint portions 10 (see FIG. 5 (A4)). Such cut edges 12 are not anodized and therefore the chips 9 having the cut edges 12 may not have sufficient insulation properties to serve as the insulating substrates.

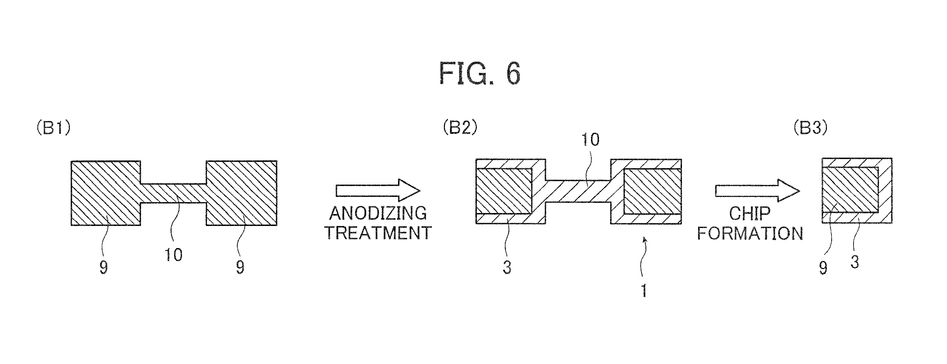

Therefore, in the practice of the invention, the joint portions 10 are formed in the process of routing so that the joint portions 10 may be smaller in thickness than the chips 9 as shown in FIG. 6 (see FIG. 6 (B1)). More specifically, the thickness of the joint portions 10 is set to at most twice as large as that of the anodized film 3 formed by anodizing treatment so that all the portions of the joint portions 10 are occupied by the anodized film 3 (see FIG. 6 (B2)).

The joint portions 10 have thus no aluminum portions and therefore the cut edges 12 of the chips 9 which serve as the insulating substrates do not emerge even after cutting the joint portions 10 (see FIG. 6 (B3)). The thus obtained chips 9 which serve as the insulating substrates have sufficient insulation properties.

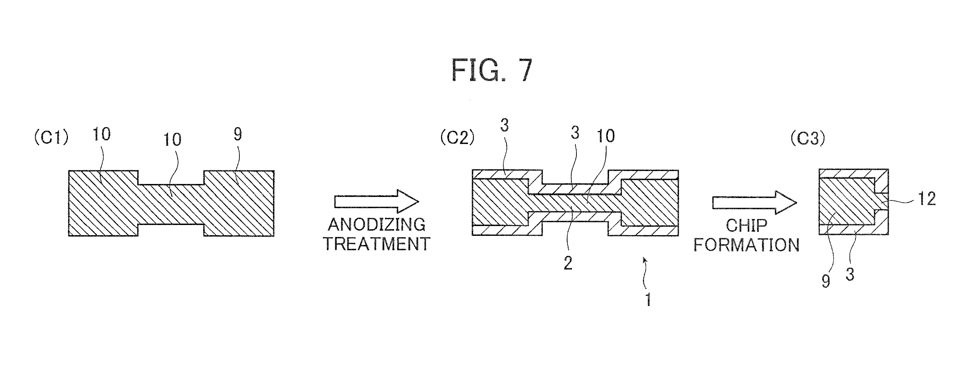

The joint portions 10 are to be formed so as to be thinner than the chips 9 but the aluminum portions remain in the joint portions 10 if the thickness of the joint portions 10 is more than twice as large as that of the anodized film 3 formed by anodizing treatment as shown in FIG. 7 (see FIG. 7 (C2)). In this case, the cut edges 12 slightly emerge at the lateral surfaces of the chips 9 after cutting the joint portions 10 (see FIG. 7 (C3)) and the insulation properties are not sufficient.

[Annealing Treatment Step]

The insulating substrate-manufacturing method of the invention may include an annealing treatment step. The annealing treatment step is a step in which the aluminum substrate is annealed before the anodizing treatment step (or before the through-hole formation step if the manufacturing method includes this step).

When the aluminum substrate is annealed, the annealing temperature is preferably from 350 to 600°C and more preferably from 400 to 500°C. The aluminum substrate is preferably annealed for 10 to 100 hours. More specifically, an exemplary method involves putting the aluminum substrate in an annealing furnace.

Such annealing treatment enables the impurities in the aluminum substrate to enter into solid solution in the substrate depending on the elemental species and therefore the number of intermetallic compound particles in the anodized film formed by anodizing treatment is reduced while exhibiting more excellent insulation properties in the insulating substrate of the invention.

The aluminum substrate having undergone annealing treatment is preferably quenched. The method of cooling is exemplified by a method involving direct immersion of the aluminum substrate in water or the like.

[Other Steps]

The insulating substrate-manufacturing method of the invention preferably includes an etching treatment step for etching the aluminum substrate to remove burr or machining oil before the anodizing treatment step (or after the through-hole formation step or chip formation step if the manufacturing method includes these steps).

An acidic treatment solution or an alkaline treatment solution may be used in etching treatment, and for example, a solution containing phosphoric acid or sodium hydroxide can be used. In this process, an organic solvent cleaner may be used in combination.

The insulating substrate-manufacturing method of the invention preferably further includes a water rinsing step for fully rinsing the whole surface of the aluminum substrate with water after the etching treatment step but before the anodizing treatment step in order to ensure the uniformity during anodizing treatment. The whole surface of the aluminum substrate is preferably not exposed to atmosphere after rinsing with water until the start of anodizing treatment in order to prevent the formation of a natural oxidation film and the adhesion of impurities in the air.

[Interconnection-Forming Method]

The interconnection-forming method of the invention is described below in detail.

The interconnection-forming method of the invention is a method for forming interconnections in desired portions on the anodized film included in the insulating substrate of the invention and includes a supply step for selectively supplying conductor metal serving as the interconnections only to the desired portions.

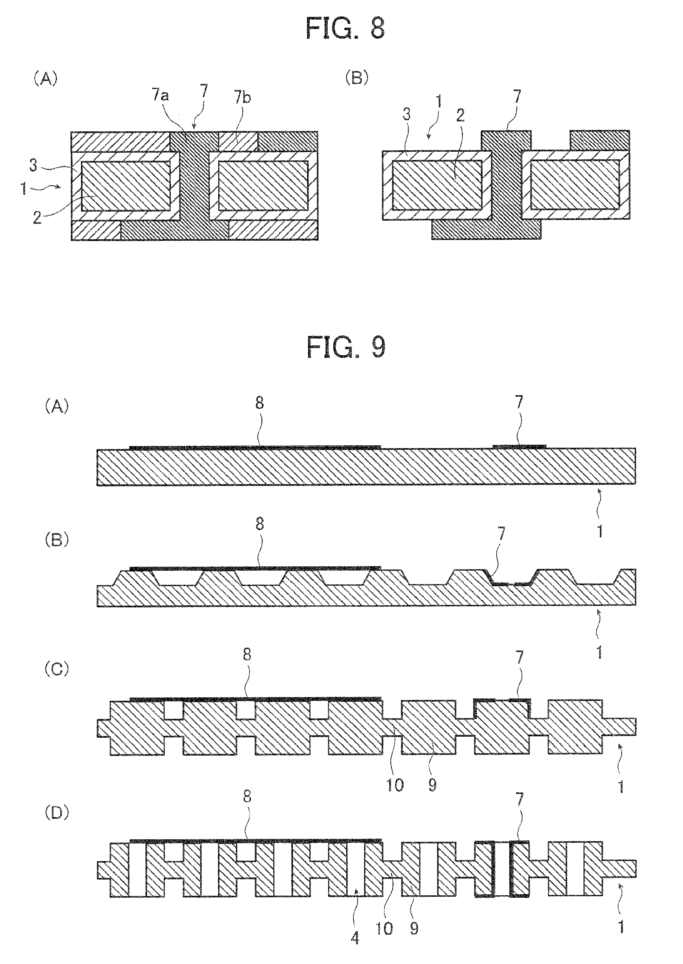

FIG. 8 shows schematic cross-sectional views for illustrating the interconnection in the insulating substrate. A possible method for forming the interconnections in the desired portions on the anodized film 3 included in the insulating substrate 1 involves, as shown in FIG. 8(A), cladding the whole surface of the anodized film 3 with conductor metal 7 (copper) using an adhesive and removing unnecessary portions 7b other than the desired portions by etching treatment or the like so that remaining portions 7a may form the interconnections.

However, if this method is adopted, a step of removing the unnecessary portions 7b by etching treatment or the like is required and the adhesive used may deteriorate the heat dissipation properties of the insulating substrate or cause other problems.

According to the interconnection-forming method of the invention, the conductor metal 7 is only selectively supplied to the desired portions from the beginning as shown in FIG. 8(B) and therefore interconnections can be formed in the desired portions without the need to remove the unnecessary portions 7b by etching treatment or the like.

The interconnections obtained by the interconnection-forming method of the invention have the same conduction properties as those obtained by supplying the conductor metal 7 to the whole surface of the anodized film 3, and particularly by adopting the first to fourth interconnection-forming methods to be described later, the use of an adhesive is not necessary and the heat dissipation properties of the insulating substrate are maintained.

FIG. 9 shows schematic views for illustrating the supply of conductor metal. The case of supplying the conductor metal is described below with reference to FIG. 9.

In cases where the insulating substrate 1 is in the shape of an even plate as shown in FIG. 9(A), a metal foil layer 8 made of conductor metal can be provided on the anodized film (not shown in FIG. 9) of the insulating substrate 1 without using the interconnection forming method of the invention.

However, in cases where the insulating substrate 1 has a textured shape, such as a shape having irregularities on one surface side (cavity shape); a shape in which the chips 9 are connected together through the joint portions 10 (plastic model shape); or a shape in which the through-holes 4 are formed in the chips 9 (through-hole shape) as shown in FIGS. 9(B) to 9(D), the metal foil layer 8 is difficult to form along these shapes.

When the insulating substrate 1 has a textured shape, by adopting the interconnection forming method of the invention which involves selectively supplying the conductor metal 7 only to desired portions, the conductor metal 7 can be partially supplied to the insulating substrate 1 having the textured shape to form the interconnections. In this process, the portions which are desired to have the interconnections formed may be positioned on both the sides of the insulating substrate 1 as shown in FIG. 9(D).

In the case of the insulating substrate 1 having a through-hole shape, the third interconnection forming method or the fourth interconnection forming method as will be described later is preferably adopted in terms of supplying the conductor metal 7 to the inner wall surfaces of the through-holes 4 as well.

Next, the interconnection forming methods of the invention including the first to fourth interconnection forming methods are described.

[First Interconnection Forming Method]

The supply step in the first interconnection forming method is a step in which metal ink containing conductor metal is supplied to desired portions on the anodized film by ink-jet printing. According to the first interconnection forming method, the metal ink forms an interconnection pattern, which is then baked to form interconnections.

In the insulating substrate having the anodized film formed up to the end faces (lateral surfaces) as in the insulating substrate of the invention, the effect of easily supplying the metal ink can be expected by adopting the first interconnection forming method.

The mechanism that may be used in ink-jet printing is not particularly limited and conventionally known mechanisms may be used.

An example of the metal ink includes one which is obtained by uniformly dispersing a particulate conductor metal in a solvent containing, for example, a binder and a surfactant. In this case, the solvent should have affinity for the conductor metal and volatility.

Examples of the conductor metal contained in the metal ink include microparticles of metals such as silver, copper, gold, platinum, nickel, aluminum, iron, palladium, chromium, molybdenum and tungsten; microparticles of metal oxides such as silver oxide, cobalt oxide, iron oxide and ruthenium oxide; microparticles of composite alloys such as Cr-Co-Mn-Fe, Cr-Cu, Cr-Cu-Mn, Mn-Fe-Cu, Cr-Co-Fe, Co-Mn-Fe and Co-Ni-Cr-Fe; and microparticles of plated composites such as copper plated with silver. These may be used alone or in combination of two or more thereof.

Of these, metal microparticles are preferable and silver, copper and gold are more preferable. Silver is particularly preferable because of the excellent oxidation resistance, high resistance to generation of highly insulating oxides, low cost and improved conductivity after the interconnection pattern is baked.

The shape of the particulate conductor metal is not particularly limited and examples thereof include a spherical shape, a granular shape and a scale-like shape. The scale-like shape is preferable in terms of improving the electrical conductivity by increasing the contact area between the microparticles.

In terms of improving the electrical conductivity by increasing the filling factor in the interconnection pattern formed with the metal ink and supplying the anodized film on the insulating substrate of the invention with the metal ink, the conductor metal particles contained in the metal ink have an average size of preferably 1 to 20 nm and more preferably 5 to 10 nm.

[Second Interconnection Forming Method]

The supply step in the second interconnection forming method is a step in which metal ink containing conductor metal is supplied to desired portions on the anodized film by screen printing. According to the second interconnection forming method, as in the first interconnection forming method, the metal ink forms interconnection patterns, which are then baked to form interconnections.

In the screen printing, the metal ink is supplied by forming permeable portions corresponding to an interconnection pattern in a screen and squeezing the metal ink through the permeable portions.

Conductor metal-containing metal inks used in the above-described ink-jet printing may be employed.

[Third Interconnection Forming Method]

The supply step in the third interconnection forming method is a step in which a conductor metal ion-containing treatment solution is used to perform electroless plating and/or electrolytic plating on the insulating substrate of the invention having a resist formed in portions other than the desired portions on the anodized film. According to the third interconnection forming method, the conductor metal can only be deposited to the desired portions on the anodized film where no resist is formed, thereby obtaining the interconnections.

The method of forming the resist on the anodized film is not particularly limited and conventionally known methods may be used, as exemplified by a method which involves drying the insulating substrate of the invention immersed in a resist solution to form a resist on the whole surface of the anodized film, exposing the resist according to the interconnection pattern, and developing to remove unnecessary resist portions.

The resist is not particularly limited and a conventionally known resist can be used as long as the anodized film can be covered therewith. It is not preferable to use a film-type resist when the insulating substrate of the invention has a textured shape due to the presence of through-holes.

When the insulating substrate of the invention is used, the resist may be removed or remain intact. When the resist is made to remain intact, oxide fillers such as alumina, silica and titania are preferably incorporated in the resist so that the heat dissipation properties of the insulating substrate of the invention may not be deteriorated.

Exemplary treatment solutions that may be used in electroless plating include those containing ions of conductor metals such as Ni, Au, Cu and Pd. Of these, treatment solutions containing Cu, Ni and Au ions are preferable.

Exemplary treatment solutions that may be used in electrolytic plating include those containing ions of conductor metals such as Cu, Ni and Au. Of these, treatment solutions containing Cu ions are preferable.

The conditions of electroless plating and/or electrolytic plating are not particularly limited as long as the deposited conductor metal can grow to a film thickness capable of electric conduction. Electroless plating may only be performed by immersing the insulating substrate of the invention in the electroless plating solution for a long time until the conductor metal forms a film with a desired thickness. Alternatively, the conductor metal may be grown to a given film thickness by electroless plating and then further grown by electrolytic plating.

[Fourth Interconnection Forming Method]

The supply step in the fourth interconnection forming method is a step in which a metal-reducing layer having the metal-reducing ability is formed in the desired portions on the anodized film and the thus formed metal-reducing layer is brought into contact with a conductor metal ion-containing treatment solution. According to the fourth interconnection forming method, the conductor metal can only be deposited on the desired portions where the metal-reducing layer is formed, thereby obtaining the interconnections.

For example, a treatment solution obtained by previously binding a metal having the metal-reducing ability to a coupling agent containing a functional group having the metal-binding ability is printed in the desired portions on the anodized film by ink-jet printing or screen printing and then dried to form the metal-reducing layer.

The coupling agent is not particularly limited as long as it has a functional group which may react with hydroxyl group on the anodized film, and a silane coupling agent which may generate highly reactive silanol group is preferable.

Examples of the functional group having the metal-binding ability which is contained in the coupling agent include mercapto group, carboxy group, 2-hydroxyphenyl group, 3-hydroxyphenyl group, 4-hydroxyphenyl group, ester group, amide group, imidazole group and ether group. Of these, mercapto group is preferable because it has more excellent metal-binding ability.

An example of the coupling agent includes $\gamma$-mercaptopropyltrimethoxysilane [$(CH_3O)_3SiC_3H_6SH$].

Examples of the metal having the metal-reducing ability which is bound to the coupling agent include Pd, Ag and Au. Of these, Pd (palladium) is preferable because it has more excellent metal-reducing ability.

Exemplary conductor metal ions contained in the treatment solution to be brought into contact with the metal-reducing layer include metal ions such as Ag, Ni, Au, Cu and Pd. Of these, Cu is preferable.

Treatment solutions for use in the above-described electroless plating may be preferably used as such a treatment solution.

2. Second Aspect

[Insulating Substrate]

The insulating substrate of the invention is described below in detail.

The insulating substrate of the invention is the one having a metal substrate and an insulation layer formed at a surface of the metal substrate, the metal substrate being a valve metal substrate, the insulation layer being an anodized film of a valve metal, and the anodized film having a porosity of 30% or less.

Then, the metal substrate (valve metal substrate) and the insulation layer (anodized film of the valve metal) making up the insulating substrate of the invention are described below.

[Metal Substrate]

The metal substrate that may be used in the insulating substrate of the invention is a substrate made of a valve metal.

The valve metal as used herein has the property that the surface of the metal is covered with the oxide film of the metal by anodization and also the property that the oxide film passes the current only in one direction and hardly passes the current in the opposite direction. Specific examples of the valve metal include aluminum, tantalum, niobium, titanium, hafnium, zirconium, zinc, tungsten, bismuth and antimony.

Of these, an aluminum substrate is preferable because it contributes to good light source permeability in the light-emitting device and has also excellent workability and strength.

[Aluminum Substrate]

Any known aluminum substrate may be used as the aluminum substrate advantageously used in the insulating substrate of the invention. Use may also be made of pure aluminum substrates; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered with high-purity aluminum by a process such as vapor deposition or sputtering; and resin substrates on which aluminum has been laminated.

Other elements which may be present in the alloy plate include silicon, iron, copper, manganese, magnesium, chromium, zinc, bismuth, nickel and titanium. The content of other elements in the alloy is preferably up to 10 wt%.

Aluminum substrates that may be advantageously used in the insulating substrate of the invention are not specified as to composition, but include known materials that appear in the 4th edition of Aluminum Handbook published in 1990 by the Japan Light Metal Association, such as aluminum substrates having the designations JIS A1050, JIS A1100 and JIS A1070, and manganese-containing Al-Mn aluminum substrates having the designation JIS A3004 and International Alloy Designation 3103A. Al-Mg alloys and Al-Mn-Mg alloys (JIS A3005) composed of the above aluminum alloys to which at least 0.1 wt% of magnesium has been added may also be used to increase the tensile strength. Al-Zr alloys and Al-Si alloys which additionally contain zirconium and silicon, respectively may also be used. Use may also be made of Al-Mg-Si alloys.

JIS 1050 materials are mentioned in JP 59-153861 A, JP 61-51395 A, JP 62-146694 A, JP 60-215725 A, JP 60-215726 A, JP 60-215727 A, JP 60-216728 A, JP 61-272367 A, JP 58-11759 A, JP 58-42493 A, JP 58-221254 A, JP 62-148295 A, JP 4-254545 A, JP 4-165041 A, JP 3-68939 B, JP 3-234594 A, JP 1-47545 B, JP 62-140894 A, JP 1-35910 B and JP 55-28874 B.

JIS 1070 materials are mentioned in JP 7-81264 A, JP 7-305133 A, JP 8-49034 A, JP 8-73974 A, JP 8-108659 A and JP 8-92679 A.

Al-Mg alloys are mentioned in JP 62-5080 B, JP 63-60823 B, JP 3-61753 B, JP 60-203496 A, JP 60-203497 A, JP 3-11635 B, JP 61-274993 A, JP 62-23794 A, JP 63-47347 A, JP 63-47348 A, JP 63-47349 A, JP 64-1293 A, JP 63-135294 A, JP 63-87288 A, JP 4-73392 B, JP 7-100844 B, JP 62-149856 A, JP 4-73394 B, JP 62-181191 A, JP 5-76530 B, JP 63-30294 A, JP 6-37116 B, JP 2-215599 A and JP 61-201747 A.

Al-Mn alloys are mentioned in JP 60-230951 A, JP 1-306288 A, JP 2-293189 A, JP 54-42284 B, JP 4-19290 B, JP 4-19291 B, JP 4-19292 B, JP 61-35995 A, JP 64-51992 A, JP 4-226394 A, US 5,009,722 and US 5,028,276.

Al-Mn-Mg alloys are mentioned in JP 62-86143 A, JP 3-222796 A, JP 63-60824 B, JP 60-63346 A, JP 60-63347 A, JP 1-293350 A, EP 223,737 B, US 4,818,300 and GB 1,222,777.

Al-Zr alloys are mentioned in JP 63-15978 B, JP 61-51395 A, JP 63-143234 A and JP 63-143235 A.

Al-Mg-Si alloys are mentioned in GB 1,421,710.

The aluminum alloy may be formed into a plate by, for example, the method described below.
First, an aluminum alloy melt that has been adjusted to a given alloying ingredient content is subjected to cleaning treatment by an ordinary method, then is cast. Cleaning treatment, which is carried out to remove hydrogen and other unnecessary gases from the melt, typically involves flux treatment; degassing treatment using argon gas, chlorine gas or the like; filtering treatment using, for example, what is referred to as a rigid media filter (e.g., ceramic tube filters, ceramic foam filters), a filter that employs a filter medium such as alumina flakes or alumina balls, or a glass cloth filter; or a combination of degassing treatment and filtering treatment.

Such cleaning treatment is preferably carried out to prevent defects due to foreign matter such as nonmetallic inclusions and oxides in the melt, and defects due to dissolved gases in the melt. Melt filtration is described in, for example, JP 6-57432 A, JP 3-162530 A, JP 5-140659 A, JP 4-231425 A, JP 4-276031 A, JP 5-311261 A, and JP 6-136466 A. Melt degassing is described in, for example, JP 5-51659 A and JP 5-49148 U. The present applicant proposes a technique concerning the melt degassing in JP 7-40017 A.

Next, the melt that has been subjected to cleaning treatment as described above is cast. Exemplary casting processes include a casting process using a stationary mold as typified by a DC casting process and a casting process using a moving mold typified by a continuous casting process.
In DC casting, the melt is solidified at a cooling speed of 0.5 to 30°C per second. At less than 1°C/s, many coarse intermetallic compound particles may be formed. When DC casting is carried out, an ingot having a thickness of 300 to 800 mm can be obtained. If necessary, this ingot is scalped by a conventional method, generally removing 1 to 30 mm, and preferably 1 to 10 mm, of material in the surface layer. The ingot is optionally soaked, either before or after scalping. In cases where soaking is carried out, the ingot is heat treated at 450 to 620°C for 1 to 48 hours to prevent the coarsening of intermetallic compound particles. The effects of soaking treatment may be inadequate if heat treatment time is shorter than one hour.

The ingot is then hot-rolled and cold-rolled, giving a rolled aluminum substrate. A temperature of 350 to 500°C at the start of hot rolling is appropriate. Intermediate annealing may be carried out before or after hot rolling, or even during hot rolling. The intermediate annealing conditions may consist of 2 to 20 hours of heating at 280 to 600°C, and preferably 2 to 10 hours of heating at 350 to 500°C, in a batch-type annealing furnace, or of heating for up to 6 minutes at 400 to 600°C, and preferably up to 2 minutes at 450 to 550°C, in a continuous annealing furnace. Using a continuous annealing furnace to heat the rolled plate at a temperature rise rate of 10 to 200°C/s enables a finer crystal structure to be achieved.

The aluminum substrate finished into a given thickness as in a range of 0.1 to 0.5 mm by the above-described steps may be further treated by a leveling apparatus such as a roller leveler or a tension leveler to improve the flatness. The flatness may be improved after the aluminum substrate has been cut into discrete sheets. However, to enhance productivity, it is preferable to improve the flatness of the aluminum substrate in the state of a continuous coil. It is also possible to feed the aluminum substrate into a slitter line so as to form it into a given plate width. A thin film of oil may be provided on the aluminum substrate surface to prevent scuffing due to friction between adjoining aluminum substrates. Suitable use may be made of either a volatile or non-volatile oil film, as needed.

Continuous casting processes that are industrially carried out include processes which use cooling rolls, such as the twin roll process (Hunter process) and the 3C process; and processes which use a cooling belt or a cooling block, such as the twin belt process (Hazelett process) and the Alusuisse Caster II process. When a continuous casting process is used, the melt is solidified at a cooling rate of 100 to 1,000°C/s. Continuous casting processes generally have a faster cooling rate than DC casting processes, and thus are characterized by the ability to achieve a higher solid solubility of alloying ingredients in the aluminum matrix. The techniques relating to continuous casting processes that have been proposed by the present applicant are described in, for example, JP 3-79798 A, JP 5-201166 A, JP 5-156414 A, JP 6-262203 A, JP 6-122949 A, JP 6-210406 A and JP 6-26308 A.

When continuous casting is carried out by, for example, a process involving the use of cooling rolls (e.g., the Hunter process), the melt can be directly and continuously cast as a plate having a thickness of 1 to 10 mm, thus making it possible to omit the hot rolling step. When use is made of a process that employs a cooling belt (e.g., the Hazelett process), a cast plate having a thickness of 10 to 50 mm can be obtained. Generally, a hot rolling mill is positioned immediately downstream of a casting machine, and the cast plate is successively rolled, enabling a continuously cast and rolled plate having a thickness of 1 to 10 mm to be obtained.

These continuously cast and rolled plates are then subjected to such processes as cold rolling, intermediate annealing, flattening and slitting in the same way as described above for DC casting, and thereby finished to a plate thickness of, for example, 0.1 to 0.5 mm. Technology proposed by the applicant of the invention concerning the intermediate annealing conditions and cold rolling conditions in a continuous casting process is described in, for example, JP 6-220593 A, JP 6-210308 A, JP 7-54111 A and JP 8-92709 A.

Because the crystal structure at the surface of the aluminum substrate may give rise to a poor surface quality when chemical graining treatment or electrochemical graining treatment is carried out, it is preferable that the crystal structure of the aluminum substrate not be too coarse. The crystal structure at the surface of the aluminum substrate has a width of preferably up to 200 $\mu$m, more preferably up to 100 $\mu$m, and even more preferably up to 50 $\mu$m. Moreover, the crystal structure has a length of preferably up to 5,000 $\mu$m, more preferably up to 1,000 $\mu$m, and even more preferably up to 500 $\mu$m. Related technology proposed by the applicant of the invention is described in, for example, JP 6-218495 A, JP 7-39906 A and JP 7-124609 A.

It is preferable for the alloying ingredient distribution at the surface of the aluminum substrate to be reasonably uniform because non-uniform distribution of alloying ingredients at the surface of the aluminum substrate sometimes leads to a poor surface quality when chemical graining treatment or electrochemical graining treatment is carried out. Related technology proposed by the applicant of the invention is described in, for example, JP 6-48058 A, JP 5-301478 A and JP 7-132689 A.

The size or density of intermetallic compound particles in the aluminum substrate may affect chemical graining treatment or electrochemical graining treatment. Related technology proposed by the applicant of the invention is described in, for example, JP 7-138687 A and JP 4-254545 A.

In the invention, the aluminum substrate as described above may be used after a textured pattern has been formed on the aluminum substrate in the final rolling process or the like by pack rolling, transfer or other method.

The aluminum substrate that may be advantageously used in the insulating substrate of the invention may be in the form of an aluminum web or a cut sheet.

When the aluminum substrate is in the form of a web, it may be packed by, for example, laying hardboard and felt on an iron pallet, placing corrugated cardboard doughnuts on either side of the product, wrapping everything with polytubing, inserting a wooden doughnut into the opening at the center of the coil, stuffing felt around the periphery of the coil, tightening steel strapping about the entire package, and labeling the exterior. In addition, polyethylene film can be used as the outer wrapping material, and needled felt and hardboard can be used as the cushioning material. Various other forms of packing exist, any of which may be used so long as the aluminum substrate can be stably transported without being scratched or otherwise marked.

The aluminum substrate that may be advantageously used in the invention has a thickness of about 0.1 to about 2.0 mm, preferably 0.15 to 1.5 mm, and more preferably 0.2 to 1.0 mm. This thickness can be changed as appropriate according to the desires of the user.

[Insulation Layer]

The insulation layer that may be used in the insulating substrate of the invention is a layer formed at a surface of the metal substrate (valve metal substrate) and is the anodized film of the above-described valve metal.

The insulation layer formed may be an anodized film of a valve metal substrate different from the valve metal substrate but is preferably an anodized film formed on the valve metal substrate by subjecting part (surface) of the valve metal substrate to anodizing treatment to be described later in terms of preventing formation defects of the insulation layer.

In the practice of the invention, the anodized film has a porosity of up to 30%, preferably up to 15% and more preferably up to 5%.

The porosity of the anodized film as used herein refers to a value calculated by the following formula: In the following formula, the density ($g/cm^3$) of valve metal oxides refers to the density described in Chemical Handbook or the like. For example, the density of aluminum oxide is 3.98 and that of titanium oxide is 4.23.

$$\texttt{Porosity (\%) = [1 - (density of oxide film / density of}$$

$$\texttt{valve metal oxide)] x 100}$$

(wherein the density ($g/m^3$) of the oxide film represents the weight of the oxide film per unit area divided by the thickness of the oxide film.)

A light-emitting device having excellent insulation properties and heat dissipation properties can be provided by using the anodized film having such a porosity in the insulation layer.

This is presumably because the amount of air present in the pores of the anodized film is reduced without affecting the composition and thickness of the anodized film, consequently increasing the thermal conductivity while maintaining excellent insulation properties of the anodized film.

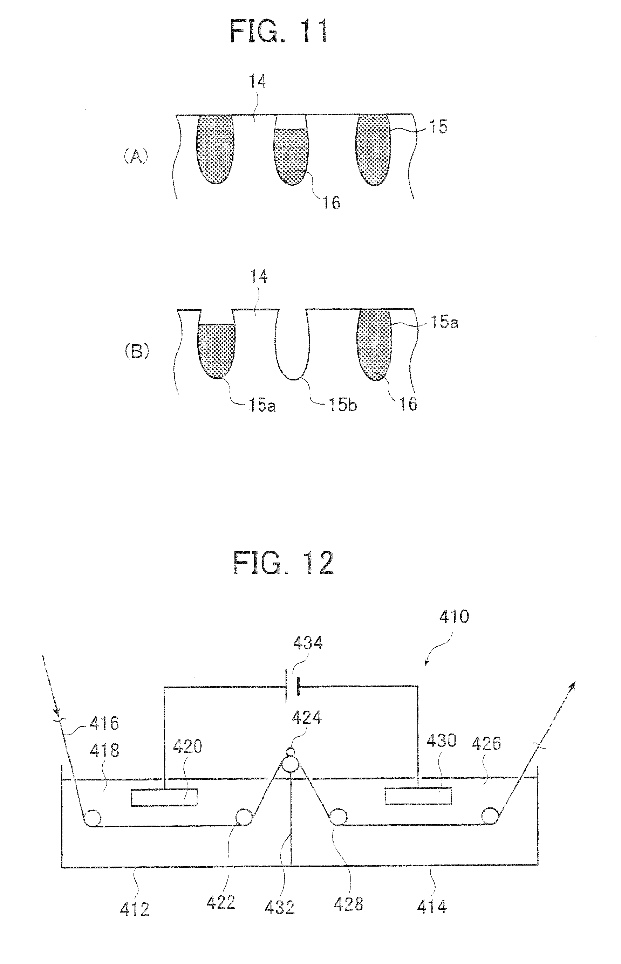

In the practice of the invention, as shown in FIG. 11, at least part of the interior of each of the micropores 15 in the anodized film 14 is preferably sealed with a substance 16 different from the substance making up the anodized film 14 in order to further improve the insulation properties (see FIG. 11(A)) and the micropores in the anodized film 14 preferably include micropores 15a, the interior of which is at least partly sealed with the substance 16 different from the substance making up the anodized film 14, and micropores 15b, the interior of which is not sealed with the different substance (see FIG. 11(B)) in order to improve the adhesion to the metal interconnection layer to be described later.

The substance different from the substance making up the anodized film preferably has insulation properties. When the anodized film is an anodized aluminum (aluminum oxide) film, specific examples of the substance include aluminum hydroxide, titanium oxide, silicon oxide, magnesium oxide, tantalum oxide, niobium oxide, zirconium oxide, and hydrates thereof. These may be used alone or in combination of two or more thereof.

Of these, aluminum hydroxide and hydrates thereof are preferable because they have a refractive index close to that of aluminum oxide, contribute to good light source permeability in the light-emitting device, adsorb well onto aluminum oxide, and have excellent insulation properties.

In addition, in the practice of the invention, the insulation layer may be formed on both the surfaces of the metal substrate or on the end surfaces of the metal substrate depending on the application of the light-emitting device.

Particularly when used as the insulating substrate for white LEDs, the surfaces of the metal substrate and the insulation layer making up the insulating substrate of the invention may have a predetermined surface shape in terms of increasing the diffuse reflection light component.

As for the surface shape, a shape having topographic features with an average wavelength of 0.01 to 100 $\mu$m is preferable and a shape in which topographic features with different wavelengths are superimposed on one another may be applied. It is estimated that such a surface shape may improve the light diffusion effect while suppressing the emitted light absorption effect and interference effect (the effect which may cause reflection loss).

The treatment for forming such a surface shape is preferably carried out under various mechanical/electric/chemical treatment conditions as described, for example, in paragraphs [0049] to [0076] of JP 2007-245116 A.

In particular, the surface of the insulation layer (anodized film) making up the insulating substrate of the invention preferably has topographic features with an average diameter of at least 1 $\mu$m at an average pitch of up to 0.5 $\mu$m, because the adhesion to the metal interconnection layer to be described later which is formed in consideration of the mounting of an LED is good and the deterioration of the reflection characteristics in non-interconnected portions can be suppressed.

In the practice of the invention, the topographic features can also be formed by sealing part (e.g., about 80 to 90%) of the interior of the micropores included in the anodized film with the above-mentioned different substance.

[Insulating Substrate-Manufacturing Method]

The method of manufacturing the insulating substrate of the invention is described below in detail.

The insulating substrate-manufacturing method of the invention is a method of manufacturing the above-described insulating substrate of the invention, and includes:

an anodizing treatment step for anodizing a surface of the valve metal substrate to form the anodized film of the valve metal on the valve metal substrate; and

a sealing treatment step for sealing after the anodizing treatment step to adjust the porosity of the anodized film to 30% or less.

Next, the anodizing treatment step and the sealing treatment step are described.

[Anodizing Treatment Step]

The anodizing treatment step is a treatment step for anodizing the surface of the metal substrate to form a porous or non-porous portion-containing insulation layer at the surface of the metal substrate.

Anodizing treatment in the anodizing treatment step can be performed by a conventional method used in the manufacture of a lithographic printing plate support.

More specifically, the solution that may be used in anodizing treatment may contain acids such as sulfuric acid, phosphoric acid, chromic acid, oxalic acid, sulfamic acid, benzenesulfonic acid, amidosulfonic acid, malonic acid, citric acid, tartaric acid and boric acid, and hydroxides of alkali metals and alkaline-earth metals such as sodium hydroxide, magnesium hydroxide, potassium hydroxide, and calcium hydroxide. The acids and hydroxides may be used alone or in combination of two or more.

It is acceptable for at least ingredients ordinarily present in the aluminum substrate, electrodes, tap water, groundwater and the like to be present in the electrolytic solution. In addition, secondary and tertiary ingredients may be added. Here, "secondary and tertiary ingredients" includes, for example, the ions of metals such as Na, K, Mg, Li, Ca, Ti, Al, V, Cr, Mn, Fe, Co, Ni, Cu and Zn; cations such as ammonium ion; and anions such as nitrate ion, carbonate ion, chloride ion, phosphate ion, fluoride ion, sulfite ion, titanate ion, silicate ion and borate ion. These may be present in concentrations of about 0 to 10,000 ppm.

The anodizing treatment conditions in the anodizing treatment step vary depending on the electrolytic solution used and thus cannot be strictly specified. However, it is generally suitable for the solution to have an electrolyte concentration of 1 to 80 wt% and a temperature of 5 to 70°C, and for the current density to be 0.5 to 60 A/dm$^2$, the voltage to be 1 to 600 V, and the electrolysis time to be 15 seconds to 20 hours. These conditions may be adjusted to obtain the desired anodized film weight.

In addition, methods that may be used to carry out anodizing treatment in the anodizing treatment step include those described in, for example, JP 54-81133 A, JP 57-47894 A, JP 57-51289 A, JP 57-51290 A, JP 57-54300 A, JP 57-136596 A, JP 58-107498 A, JP 60-200256 A, JP 62-136596 A, JP 63-176494 A, JP 4-176897 A, JP 4-280997 A, JP 6-207299 A, JP 5-24377 A, JP 5-32083 A, JP 5-125597 A and JP 5-195291 A.

Of these, as described in JP 54-12853 A and JP 48-45303 A, it is preferable to use a sulfuric acid solution as the electrolytic solution. The electrolytic solution has a sulfuric acid concentration of preferably 10 to 300 g/L, and has an aluminum ion concentration of preferably 1 to 25 g/L, and more preferably 2 to 10 g/L. Such an electrolytic solution can be prepared by adding a compound such as aluminum sulfate to dilute sulfuric acid having a sulfuric acid concentration of 50 to 200 g/L.

When anodizing treatment is carried out in the sulfuric acid-containing electrolytic solution in the anodizing treatment step, direct current or alternating current may be applied across the aluminum substrate and the counter electrode.

When a direct current is applied to the aluminum substrate, the current density is preferably from 1 to 60 A/dm$^2$, and more preferably from 5 to 40 A/dm$^2$.

To keep burnt deposits from arising on portions of the aluminum substrate due to the concentration of current when anodizing treatment in the anodizing treatment step is carried out as a continuous process, it is preferable to apply current at a low current density of 5 to 10 A/dm$^2$ at the start of anodizing treatment and to increase the current density to 30 to 50 A/dm$^2$ or more as anodizing treatment proceeds. When anodizing treatment is carried out as a continuous process, this is preferably done using a system that supplies power to the aluminum substrate through the electrolytic solution.

When the anodized film is porous, the micropores have an average pore size of about 5 to about 1,000 nm and an average pore density of about 1 x 10$^6$ to 1 x about 10$^{10}$ pcs/mm$^2$. The porosity of the anodized film approximating the ratio of the micropores in the anodized film is preferably from 1 to 90%, more preferably from 5 to 80% and most preferably from 10 to 70% in terms of facilitating sealing treatment to be described later. The method of calculating the porosity is as described above.

The thickness of the anodized film is preferably 1 to 200 $\mu$m. A film thickness of less than 1 $\mu$m reduces the withstand voltage due to poor insulation properties, whereas a film thickness in excess of 200 $\mu$m requires a large amount of electrical power and is economically disadvantageous. The anodized film has a thickness of more preferably 2 to 100 $\mu$m and even more preferably 10 to 50 $\mu$m.

Examples of electrolysis apparatuses that may be used in anodizing treatment include those described in JP 48-26638 A, JP 47-18739 A and JP 58-24517 B. An apparatus shown in FIG. 12 is particularly used with advantage. FIG. 12 is a schematic view illustrating an apparatus for anodizing the surface of an aluminum substrate. In an anodizing apparatus 410, an aluminum substrate 416 is transported as shown by arrows in FIG. 12. The aluminum substrate 416 is positively (+) charged by a power supply electrode 420 in a power supply cell 412 containing an electrolytic solution 418. The aluminum substrate 416 is then transported upward by a roller 422 disposed in the power supply cell 412, turned downward on a nip roller 424 and transported toward an electrolytic cell 414 containing an electrolytic solution 426 to be turned to a horizontal direction by a roller 428. Then, the aluminum substrate 416 is negatively (-) charged by an electrolytic electrode 430 to form an anodized film on the plate surface. The aluminum substrate 416 emerging from the electrolytic cell 414 is then transported to the section for the subsequent step. In the anodizing apparatus 410, the roller 422, the nip roller 424 and the roller 428 constitute direction changing means, and the aluminum substrate 416 is transported through the power supply cell 412 and the electrolytic cell 414 in a mountain shape and a reversed U shape by means of these rollers 422, 424 and 428. The power supply electrode 420 and the electrolytic electrode 430 are connected to a DC power supply 434.

The characteristic feature of the anodizing apparatus 410 shown in FIG. 12 is that the aluminum substrate 416 is transported in a mountain shape and a reversed U shape through the power supply cell 412 and the electrolytic cell 414 that are separated by a single cell wall 432. This configuration enables the length of the aluminum substrate 416 held in the two cells to be the shortest. Therefore, the total length of the anodizing apparatus 410 can be shortened, thus enabling a decrease in equipment costs. Transport of the aluminum plate 416 in a mountain shape and a reversed U shape eliminates the necessity of forming an opening for passing the aluminum substrate 416 through the cell wall 432 between the cells 412 and 414. The amount of electrolytic solution required for maintaining each of the liquid surfaces of the cells 412 and 414 at a necessary height can be thus suppressed to enable a decrease in running costs.

Anodizing treatment in the anodizing treatment step may be performed under a single processing condition but when the shape of the anodized film such as the shape at a specific position or the shape in the depth direction is to be controlled, anodizing treatments under two or more different conditions may be performed in combination.

Anodizing treatment for forming micropores arranged in a honeycomb array is preferably carried out by methods described in, for example, JP 3,714,507 B, JP 2002-285382 A, JP 2006-124827 A, JP 2007-231339 A, JP 2007-231405 A, JP 2007-231340 A and JP 2007-238988 A in terms of suppressing non-uniform sealing in the sealing treatment step to be described later.

These treatments are preferably those described under the treatment conditions in the foregoing patent and published patent applications.

[Sealing Treatment Step]

The sealing treatment step is a step in which sealing treatment is carried out after the anodizing treatment step to adjust the porosity of the anodized film to 30% or less, thereby obtaining the insulating substrate of the invention.

Sealing treatment in the sealing treatment step may be performed in accordance with a known method, such as boiling water treatment, hot water treatment, steam treatment, sodium silicate treatment, nitrite treatment or ammonium acetate treatment. For example, sealing treatment may be performed using the apparatuses and processes described in JP 56-12518 B, JP 4-4194 A, JP 5-202496 A and JP 5-179482 A.

In the practice of the invention, when the anodized film has micropores, not only the surface of the anodized film but also the interior of the micropores preferably receive the treatment solution for use in boiling water treatment, hot water treatment, sodium silicate treatment and the like in terms of further reducing the porosity of the anodized film while further enhancing the heat dissipation properties.

In the practice of the invention, when the anodized film has micropores, as described above, the micropores are preferably sealed with a substance different from the substance making up the anodized film in terms of further improving the insulation properties.

In sealing treatment for sealing with such a different substance, use may be made of, for example, a method in which the above-described treatment solution for use in boiling water treatment, hot water treatment, sodium silicate treatment and the like permeates the interior of the micropores to convert the substance making up the inner walls of the micropores (e.g., aluminum oxide) into another substance (e.g., aluminum hydroxide). However, sealing treatment using a sol-gel method as described in paragraphs [0016] to [0035] of JP 6-35174 A is also advantageously used.

The sol-gel method is generally a method which involves subjecting a sol made of a metal alkoxide to hydrolysis and polycondensation reaction to form a gel having no fluidity and heating the gel to form an oxide.

The metal alkoxide is not particularly limited but in terms of easily sealing into the micropores, preferable examples thereof include $Al(O\text{-}R)_n$, $Ba(O\text{-}R)_n$, $B(O\text{-}R)_n$, $Bi(O\text{-}R)_n$, $Ca(O\text{-}R)_n$, $Fe(O\text{-}R)_n$, $Ga(O\text{-}R)_n$, $Ge(O\text{-}R)_n$, $Hf(O\text{-}R)_n$, $In(O\text{-}R)_n$, $K(O\text{-}R)_n$, $La(OR)_n$, $Li(O\text{-}R)_n$, $Mg(O\text{-}R)_n$, $Mo(O\text{-}R)_n$, $Na(O\text{-}R)_n$, $Nb(O\text{-}R)_n$, $Pb(O\text{-}R)_n$, $Po(O\text{-}R)_n$, $Po(O\text{-}R)_n$, $P(O\text{-}R)_n$, $Sb(O\text{-}R)_n$, $Si(O\text{-}R)_n$, $Sn(O\text{-}R)_n$, $Sr(OR)_n$, $Ta(O\text{-}R)_n$, $Ti(O\text{-}R)_n$, $V(O\text{-}R)_n$, $W(O\text{-}R)_n$, $Y(O\text{-}R)_n$, $Zn(O\text{-}R)_n$, and $Zr(O\text{-}R)_n$ (where R represents an optionally substituted, linear, branched or cyclic hydrocarbon group or a hydrogen atom, and n represents a natural number).

Of these, titanium oxide and silicon oxide type metal alkoxides are preferable when the insulation layer includes an aluminum anodized film, in terms of excellent reactivity with aluminum oxide and excellent sol-gel forming ability.

The method of forming a sol-gel inside the micropores is not particularly limited, but a method which involves application and heating of a sol solution is preferable in terms of easily sealing it in the micropores.

The sol solution preferably has a concentration of 0.1 to 90 wt%, more preferably 1 to 80 wt% and most preferably 5 to 70 wt%.

The sol solution may be repeatedly applied to reduce the porosity.

On the other hand, as another sealing treatment for sealing with such a different substance, insulating particles of such a size as to enter the micropores included in the anodized film may be filled into the micropores.

Colloidal silica is preferable for use as such insulating particles in terms of the dispersibility and the size.

Colloidal silica may be prepared by the sol-gel method and used or commercial products may also be used. Colloidal silica may be prepared by reference to Werner Stober et al; J. Colloid and Interface Sci., 26, 62-69 (1968), Rickey D.Badley et al; Lang muir 6, 792-801 (1990), Shikizai Kyokai-shi (Journal of the Japan Society of Colour Material), 61 [9] 488-493 (1988).

Colloidal silica is a dispersion of silica in water or a water-soluble solvent containing silicon dioxide as a basic unit and its particle size is preferably from 1 to 400 nm, more preferably from 1 to 100 nm and most preferably from 5 to 50 nm. At a particle size of less than 1 nm, the storage stability of the coating solution is poor, whereas at a particle size of more than 400 nm, the filling into the micropores is deteriorated.

The colloidal silica having a particle size within the foregoing range can be used in the state of an aqueous dispersion irrespective of whether it is acidic or basic. The colloidal silica can be appropriately selected according to the stable region of the aqueous dispersion to be mixed.

Commercial products such as SNOWTEX (registered trademark; this also applies in the following description)-O, SNOWTEX-OL (Nissan Chemical Industries, Ltd.), ADELITE (registered trademark; this also applies in the following description) AT-20Q (ASAHI DENKA CORPORATION), Crebosol (registered trademark; this also applies in the following description) 20H12 and Crebosol 30CAL 25 (Clariant (Japan) K.K.) may be used.

Examples of the basic colloidal silica include those stabilized by addition of alkali metal ions, ammonium ions and amines, and use may be made of commercial products such as SNOWTEX-20, SNOWTEX-30, SNOWTEX-C, SNOWTEX-C30, SNOWTEX-CM40, SNOWTEX-N, SNOWTEX-N30, SNOWTEX-K, SNOWTEX-XL, SNOWTEX-YL, SNOWTEX-ZL, SNOWTEX PS-M and SNOWTEX PS-L (Nissan Chemical Industries, Ltd.); ADELITE AT-20, ADELITE AT-30, ADELITE AT-20N, ADELITE AT-30N, ADELITE AT-20A, ADELITE AT-30A, ADELITE AT-40 and ADELITE AT-50 (ASAHI DENKA CORPORATION); Crebosol 30R9, Crebosol 30R50 and Crebosol 50R50 (Clariant (Japan) K.K.); LUDOX (registered trademark; this also applies in the following description) HS-40, LUDOX HS-30, LUDOX LS and LUDOX SM-30 (DuPont).

For the colloidal silica using a water-soluble solvent as a dispersion medium, use may be made of commercial products including, for example, MA-ST-M (particle size: 20 to 25 nm, methanol-dispersed type), IPA-ST (particle size: 10 to 15 nm, isopropyl alcohol-dispersed type), EG-ST (particle size: 10 to 15 nm, ethylene glycol-dispersed type), EG-ST-ZL (particle size: 70 to 100 nm, ethylene glycol-dispersed type), NPC-ST (particle size: 10 to 15 nm, ethylene glycol monopropyl ether-dispersed type) available from Nissan Chemical Industries, Ltd.

These kinds of colloidal silica may be used alone or in combination of two or more and may contain a trace amount of, for example, alumina or sodium aluminate.

Further, colloidal silica may contain a stabilizer selected from, for example, inorganic bases (e.g., sodium hydroxide, potassium hydroxide, lithium hydroxide, and ammonia) and organic bases (e.g., tetramethyl ammonium).

In the practice of the invention, in cases where sealing treatment is carried out to seal the micropores with a substance different from the substance making up the anodized film, the different substance which is present near the surface layer (surface) of the anodized film is preferably removed as long as the porosity does not exceed 30%.

Removal of the different substance which is present near the surface layer facilitates the formation at the surface of the anodized film of topographic features with an average diameter of at least 1 $\mu$m at an average pitch of up to 0.5 $\mu$m, thus enhancing the adhesion to the metal interconnection layer to be described later.

The method of removing the different substance which is present near the surface layer is not particularly limited and an example thereof includes a method which involves removing only the surface layer portion by enzyme plasma treatment and immersion treatment using an aqueous sodium hydroxide solution as described in Examples to be referred to later, and mechanical polishing treatment and chemical mechanical polishing (CMP).

[Through-Hole Formation Step / Chip Formation Step]

The insulating substrate-manufacturing method of the invention may include a through-hole formation step. The through-hole formation step is a step in which the metal substrate is perforated in its thickness direction with through-holes.

The insulating substrate-manufacturing method of the invention may include a chip formation step. When the insulating substrate-manufacturing method includes the through-hole formation step, the chip formation step is a step which follows the through-hole formation step and which enables the metal substrate to be divided into individual chips with a desired shape (e.g., a size including a machining allowance necessary for the final product) and is also called "routing."

These steps may be carried out before or after the above-described anodizing treatment step. When performed before the anodizing treatment step, these steps can prevent the insulation layer formed by anodizing treatment from being cracked while maintaining the insulation properties of the end surface portions of the substrate formed by these steps. When performed after the anodizing treatment step, these steps increase the efficiency of the anodizing treatment and enable the anodized film to be precisely processed to have a size of the final product.

The shape of the through-holes formed by the through-hole formation step is not particularly limited as long as the through holes extending through a plurality of layers have a length necessary for interconnections and such a size (diameter) that can ensure the insertion of necessary interconnections. However, in consideration of the size of the final chips and more reliable interconnect formation, a circular shape is preferable. Specifically, the through-holes preferably have a diameter of 0.01 to 2 mm, more preferably 0.05 to 1 mm and most preferably 0.1 to 0.8 mm.

It is necessary to take the size and shape of the final chips into consideration when forming the chips in the chip formation step, but when a square chip is to be obtained, the length of one side is preferably 0.1 mm to 50 mm, more preferably 0.2 mm to 40 mm, and most preferably 0.4 mm to 30 mm in terms of the chip compactness and processing suitability. Particularly, when a reflecting substrate for a main package is to be obtained, routing is preferably performed in sizes of 3.2 mm x 2.8 mm and 1.6 mm x 0.8 mm which are examples of the current form standard.

When the chip formation step is followed by the above-described anodizing treatment step, a chip portion obtained after the chip formation step is preferably processed into such a shape that electrical connection to the chip portion may be achieved in order to form the insulation layer by anodizing treatment. Preferred examples thereof include a method which involves a routing process in a state where an electrical connection portion is formed and a method which involves connecting the chip portion with the use of a conductive wire or the like, but the method is not limited thereto.

In the practice of the invention, examples of the method suitable to the through-hole formation step and chip formation step include drilling, press working using a die, dicing using a dicing saw and laser processing but the method is not limited thereto.

[Protective Treatment]

In addition, in the insulating substrate-manufacturing method of the invention, a protective treatment may be carried out against various solvents that may be used in the above-described through-hole formation step and chip formation step, and treatments to be described later including formation of a metal interconnection layer for transmitting electric signals to the LED, and formation of a metal layer in the LED mounting area.

More specifically, in the protective treatment, the surface properties of the anodized film including hydrophilicity and hydrophobicity (lipophilicity and lipophobicity) can be appropriately changed as described in, for example, JP 2008-93652 A and JP 2009-68076 A. In addition, a method which involves imparting the resistance to acids and alkalis may also be appropriately used.

[Other Treatments]

In addition, according to the insulating substrate-manufacturing method of the invention, various treatments may optionally be carried out on the surface of the insulating substrate.

For example, an inorganic insulation layer made of a white insulating material (e.g., titanium oxide) or an organic insulation layer such as a white resist may be formed to enhance the whiteness of the reflecting substrate.

The insulation layer made of aluminum oxide may be colored with a desired color other than white, for example, by electrodeposition. Specifically, the insulation layer may be colored by electrolysis in an electrolytic solution containing color-stainable ion species described in, for example, Yokyoku Sanka (Anodization) edited by Metal Finishing Society of Japan, Metal Finishing Course B (1969 pp. 195-207) and Shin Arumaito Riron (New Alumite Theory), Kallos Publishing Co., Ltd. (1997 pp. 95-96), as exemplified by Co ions, Fe ions, Au ions, Pb ions, Ag ions, Se ions, Sn ions, Ni ions, Cu ions, Bi ions, Mo ions, Sb ions, Cd ions and As ions.

[Interconnection Substrate]

The interconnection substrate of the invention is described below in detail.

The interconnection substrate of the invention is one including the above-described insulating substrate of the invention and an interconnection layer provided on top of the insulating substrate on the insulation layer side.

The material of the metal interconnection layer is not particularly limited as long as it is an electrically conductive material, and specific examples thereof include gold (Au), silver (Ag), copper (Cu), aluminum (Al), magnesium (Mg) and nickel (Ni). These may be used alone or in combination of two or more thereof.

Of these, copper is preferably used because of its low electric resistance. A gold layer or a nickel/gold layer may be formed in the surface layer of the copper interconnection layer in order to enhance the ease of wire bonding.

In terms of conduction reliability and packaging compactness, the metal interconnection layer preferably has a thickness of 0.5 to 1,000 $\mu$m, more preferably 1 to 500 $\mu$m and most preferably 5 to 250 $\mu$m.

Exemplary methods of forming the metal interconnection layer include various plating treatments such as electrolytic plating, electroless plating and displacement plating, sputtering, vapor deposition, vacuum application of metal foil and adhesion using an adhesive layer.

Of these, it is preferred to form the layer only using metal in terms of its high heat resistance and it is particularly preferred to form the layer by plating in terms of forming a thick and uniform film and high adhesion.

A non-conductive material (insulating substrate) is plated and therefore a process in which a metal-reducing layer called "seed layer" is formed and the thus formed metal layer is used to form a thick metal layer is preferably used. Electroless plating is preferably used to form the seed layer and a solution containing main ingredients (e.g., metal salt and reducing agent) and auxiliary ingredients (e.g., pH adjuster, buffer, complexing agent, promoter, stabilizer and improver) is preferably used for the plating solution. Commercial products such as SE-650-666-680, SEK-670·797, SFK-63 (available from Japan Kanigen Co., Ltd.) and Melplate NI-4128, Enplate NI-433, Enplate NI-411 (available from Meltex Inc.) may be appropriately used for the plating solution.

In the case of using copper as a material of the metal interconnection layer, use may be made of various electrolytic solutions containing sulfuric acid, copper sulfate, hydrochloric acid, polyethylene glycol and a surfactant as the main ingredients and various other additives.

The thus formed metal interconnection layer is patterned by any known method according to the LED mounting design. A metal layer (including a solder) may be formed again in the portion where the LED is to be actually mounted, and appropriately processed by thermocompression bonding, flip-chip bonding or wire bonding for easier connection.

The suitable metal layer is preferably made of metal materials such as solder, gold (Au), silver (Ag), copper (Cu), aluminum (Al), magnesium (Mg) and nickel (Ni). In terms of the LED mounting under heating, a method of applying gold or silver through nickel is preferred for the connection reliability.

Specifically, an exemplary method to form gold (Au) through nickel (Ni) on a patterned copper (Cu) interconnection involves Ni strike plating and then Au plating.

Ni strike plating is carried out in order to remove the surface oxide layer of the Cu interconnection layer and ensure the adhesion to the Au layer.

A common Ni/hydrochloric acid mixed solution may be used in Ni strike plating and a commercial product such as NIPS-100 (available from Hitachi Chemical Co., Ltd.) may also be used.

On the other hand, Au plating is carried out after Ni strike plating in order to improve the wettability in wire bonding and soldering.

Au plating is preferably carried out by electroless plating and commercially available treatment solutions such as HGS-5400 (Hitachi Chemical Co., Ltd.), and MICROFAB Au Series, GALVANOMEISTER GB Series and PRECIOUSFAB IG Series (all available from Tanaka Holdings Co., Ltd.) may be used.

[White LED Light-Emitting Device]

Next, the white LED light-emitting device according to the invention is described in detail.

The white LED light-emitting device of the invention is one including the above-described interconnection substrate of the invention, a blue LED light-emitting device provided on top of the interconnection substrate on the metal interconnection layer side, and a fluorescent emitter provided at least on top of the blue LED light-emitting device.

The above-described interconnection substrate of the invention has no limitation on the shape of the light-emitting device used and the type of the LEDs, and may be used in various applications.

Next, the configuration of the white LED light-emitting devices of the invention is described with reference to drawings.

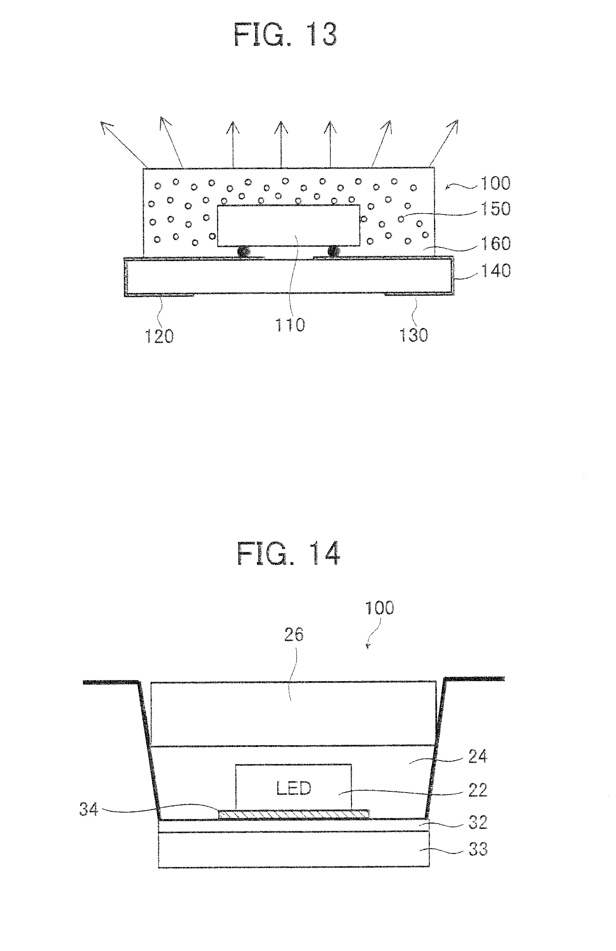

FIG. 13 is a schematic cross-sectional view illustrating a preferable example of a white LED light-emitting device of the invention.

In a white LED light-emitting device 100 shown in FIG. 13, a blue LED 110 is molded with a transparent resin 160 containing YAG phosphor particles 150, and light excited by the YAG phosphor particles 150 is combined with afterglow of the blue LED 110 to emit white light. The blue LED 110 is mounted by face-down bonding on an interconnection substrate 140 of the invention having metal interconnection layers 120, 130 which also serve as electrodes for external connection.

FIG. 14 is a schematic cross-sectional view illustrating a preferable example of the white LED light emitting device of the invention.

A white LED light-emitting device 100 shown in FIG. 14 is configured as a phosphor color mixed type, white LED light-emitting device, and includes an interconnection substrate of the invention having an insulation layer 32, a metal substrate 33 and a metal interconnection layer 34, a blue LED light-emitting device 22 provided on top of the interconnection substrate on the side of the metal interconnection layer 34, and a fluorescent emitter 26 provided at least on top of the blue LED light-emitting device 22.

As shown in FIG. 14, in the white LED light-emitting device of the invention, the blue LED light-emitting device 22 is preferably sealed with a resin 24.

In the practice of the invention, fluorescence emission units described in Japanese Patent Application Nos. 2009-134007 and 2009-139261 may be used for the fluorescent emitter 26.

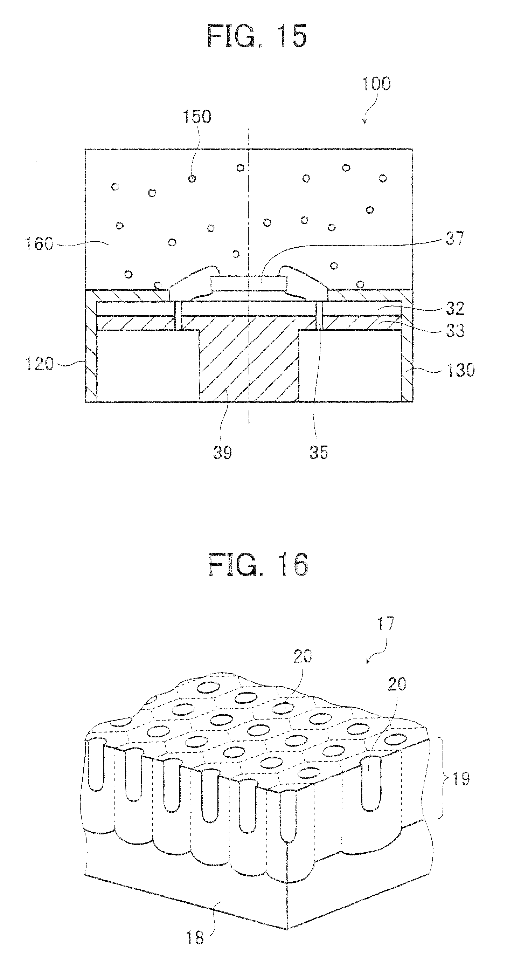

FIG. 15 is a schematic cross-sectional view illustrating the configuration of another example of the white LED light emitting device of the invention.

In a white LED light-emitting device 100 shown in FIG. 15, as in the white LED light-emitting device shown in FIG. 13, a blue LED 37 is molded with a transparent resin 160 containing YAG phosphor particles 150, and is mounted by face-down bonding on an interconnection substrate of the invention having metal interconnect layers 120, 130 which also serve as electrodes for external connection.

A configuration as shown in FIG. 15 is also possible in which through-holes 35 are formed in the interconnection substrate of the invention and a metal substrate 33 positioned below the blue LED 37 is formed so as to be thicker than the other substrate portions and serves as a heat sink 39.

Although not shown clearly in FIG. 15, the interior of the through-holes 35 in the portions of an insulation layer 32 is preferably anodized to serve as the insulation layer.

For the blue LEDs shown in FIGS. 13 and 15, ones which include a light-emitting layer of a semiconductor such as GaAlN, ZnS, ZnSe, SiC, GaP, GaAlAs, AlN, InN, AlInGaP, InGaN, GaN or AlInGaN formed on the substrate are used.

The semiconductor is, for example, of a homostructure, heterostructure or double heterostructure having an MIS junction, PIN junction or PN junction. The light-emitting wavelength may be variously selected in a range of ultraviolet light to infrared light depending on the material of the semiconductor layer and the mixture ratio thereof.

The transparent resin shown in FIGS. 13 and 15 is preferably made of a thermosetting resin.

The transparent resin is preferably made of at least one selected from the group consisting of themosetting resins such as epoxy resin, modified epoxy resin, silicone resin, modified silicone resin, acrylate resin, urethane resin and polyimide resin. Epoxy resin, modified epoxy resin, silicone resin and modified silicone resin are particularly preferred.

The transparent resin is preferably hard in order to protect the blue LED.

A resin having excellent heat resistance, weather resistance and light resistance is preferably used for the transparent resin.

At least one selected from the group consisting of filler, diffusing agent, pigment, fluorescent material, reflective material, UV absorber and antioxidant may also be mixed into the transparent resin to impart predetermined functions thereto.

In addition, the phosphor particles shown in FIGS. 13 and 15 should be of a type capable of wavelength conversion of absorbed light from the blue LED to change the wavelength of the light.

Specific examples of the phosphor particles include nitride phosphors, oxynitride phosphors, SiAlON phosphors and β-SiAlON phosphors mainly activated by lanthanoid elements such as Eu and Ce; alkaline-earth halogen apatite phosphors, alkaline-earth metal borate halogen phosphors, alkaline-earth metal aluminate phosphors, alkaline-earth silicate phosphors, alkaline-earth sulfide phosphors, alkaline-earth thiogallate phosphors, alkaline-earth silicon nitride phosphors, and germanate phosphors mainly activated by lanthanoid elements such as Eu and transition metal elements such as Mn; rare-earth aluminate phosphors and rare-earth silicate phosphors mainly activated by lanthanoid elements such as Ce; and organic complexes mainly activated by lanthanoid elements such as Eu. These may be used alone or in combination of two or more thereof.

On the other hand, the interconnection substrate of the invention may also be used as an interconnection substrate of a phosphor color mixed type, white LED light-emitting device which uses a UV to blue LED and a fluorescent emitter which absorbs light from the UV to blue LED and emits fluorescence in a visible light region.

The fluorescent emitter absorbs blue light from the blue LED to emit fluorescence (yellow fluorescence), and the fluorescence and afterglow of the blue LED cause the light-emitting device to emit white light.

This is of a so-called "pseudo-white light-emitting type" which uses a blue LED chip as the light source and a yellow phosphor in combination. The interconnection substrate of the invention may be used in the substrate of the light-emitting device in a light-emitting unit which uses other known light-emitting systems such as "UV to near-UV light source type" which uses a UV to near-UV LED chip as the light source and several types of red/green/blue phosphors in combination, and "RGB light source type" which emits white light from the three light sources of red, green and blue colors.

The method of mounting the LED device on the interconnection substrate of the invention involves heating, and in the mounting method involving thermocompression bonding including reflow soldering and flip chip bonding, the maximum temperature reached is preferably from 220°C to 350°C, more preferably from 240°C to 320°C and most preferably from 260°C to 300°C in terms of uniform and reliable mounting.

The maximum temperature reached is preferably kept for 2 seconds to 10 minutes, more preferably from 5 seconds to 5 minutes and most preferably from 10 seconds to 3 minutes for the same reason as above.

In order to prevent cracks from occurring in the anodized layer due to a difference in the coefficient of thermal expansion between the metal substrate and the anodized film, a heat treatment may also be performed before reaching the maximum temperature at a desired constant temperature for preferably 5 seconds to 10 minutes, more preferably 10 seconds to 5 minutes and most preferably 20 seconds to 3 minutes. The desired constant temperature is preferably from 80°C to 200°C, more preferably from 100°C to 180°C and most preferably from 120°C to 160°C.

The temperature upon mounting by wire bonding is preferably 80°C to 300°C, more preferably 90°C to 250°C and most preferably 100°C to 200°C in terms of reliable mounting. The heating time is preferably 2 seconds to 10 minutes, more preferably 5 seconds to 5 minutes and most preferably 10 seconds to 3 minutes.

3. Third Aspect

[Insulating Substrate]

The insulating substrate of the invention is described below in detail.

The insulating substrate of the invention is the one including an aluminum substrate and an insulation layer formed at a surface of the aluminum substrate, the insulation layer including an aluminum anodized film having micropores, the insulating substrate having a thickness of up to 1,500 $\mu$m, the anodized film having a thickness of at least 5 $\mu$m, a ratio ($T_A/T_O$) of the thickness ($T_A$) of the insulating substrate to the thickness ($T_O$) of the anodized film being from 2.5 to 300, and of the thicknesses of the anodized film in the depth direction, the thickness of a portion where no micropore is formed being at least 30 nm.

Next, the structure of the insulating substrate of the invention is described with reference to FIG. 16.

FIG. 16 is a schematic view illustrating a preferred embodiment of the insulating substrate of the invention.

As shown in FIG. 16, an insulating substrate 17 of the invention includes an aluminum substrate 18 and an insulation layer 19 formed at a surface of the aluminum substrate 18.

As shown in FIG. 16, the insulation layer 19 has micropores 20.

The materials and sizes of the aluminum substrate and the insulation layer (aluminum anodized film) and their forming methods are described below in detail.

[Aluminum Substrate]

Any known aluminum substrate may be used as the aluminum substrate making up the insulating substrate of the invention. Use may also be made of pure aluminum substrates; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered with high-purity aluminum by a process such as vapor deposition or sputtering; and resin substrates on which aluminum has been laminated.

In the practice of the invention, in cases where an aluminum substrate obtained by coating (laminating) a silicon wafer or a resin substrate with aluminum is used, the thickness of the insulating substrate of the invention (1,500 $\mu$m or less) does not include the thickness of the silicon wafer or the resin substrate.

In the practice of the invention, when the aluminum substrate is to be subjected to anodizing treatment to be described later, the surface to be anodized preferably has a higher aluminum purity.

More specifically, the aluminum purity is preferably at least 99.5 wt%, more preferably at least 99.9 wt% and even more preferably at least 99.99 wt%.

In particular, at an aluminum purity within the foregoing range, the orderliness of the array of micropores present in the insulation layer formed by anodizing treatment is sufficient and the uniformity in the luminance of the light-emitting device is improved when the aluminum substrate is used as a transmission grating or a transmission light scattering layer of the light-emitting device.

In the practice of the invention, the surface of the aluminum substrate on which the subsequently described anodizing treatment is to be carried out is preferably subjected beforehand to degreasing treatment and mirror-like finishing treatment. The aluminum substrate surface is most preferably subjected to heat treatment in order to improve the orderliness of the array of micropores.

In addition, in the practice of the invention, the aluminum substrate surface may also be roughened according to the intended use of the LED material to be mounted on the insulating substrate of the invention, for example, in terms of forming the surface from which light is scattered.

[Heat Treatment]

Heat treatment is preferably carried out at a temperature of 200 to 350°C for a period of about 30 seconds to about 2 minutes. More specifically, an exemplary method involves putting an aluminum substrate in a heated oven. Such a heat treatment improves the orderliness of the array of micropores formed by anodizing treatment to be described later.

It is preferable to rapidly cool the heat-treated aluminum substrate. The method of cooling is exemplified by a method involving direct immersion of the aluminum substrate in water or the like.

[Degreasing Treatment]

Degreasing treatment is carried out with a suitable substance such as an acid, alkali or organic solvent so as to dissolve and remove organic substances, including dust, grease and resins, adhering to the aluminum substrate surface, and thereby prevent defects due to organic substances from arising in each of the subsequent treatments.

Illustrative examples of degreasing treatment include: a method in which an organic solvent such as an alcohol (e.g., methanol), ketone (e.g., methyl ethyl ketone), petroleum benzin or volatile oil is contacted with the surface of the aluminum substrate at ambient temperature (organic solvent method); a method in which a liquid containing a surfactant such as soap or a neutral detergent is contacted with the surface of the aluminum substrate at a temperature of from ambient temperature to 80°C, after which the surface is rinsed with water (surfactant method); a method in which an aqueous sulfuric acid solution having a concentration of 10 to 200 g/L is contacted with the surface of the aluminum substrate at a temperature of from ambient temperature to 70°C for a period of 30 to 80 seconds, following which the surface is rinsed with water; a method in which an aqueous solution of sodium hydroxide having a concentration of 5 to 20 g/L is contacted with the surface of the aluminum substrate at ambient temperature for about 30 seconds while electrolysis is carried out by passing a direct current through the aluminum substrate surface as the cathode at a current density of 1 to 10 A/dm$^2$, following which the surface is contacted with an aqueous solution of nitric acid having a concentration of 100 to 500 g/L and thereby neutralized; a method in which any of various known anodizing electrolytic solutions is contacted with the surface of the aluminum substrate at ambient temperature while electrolysis is carried out by passing a direct current at a current density of 1 to 10 A/dm$^2$ through the aluminum substrate surface as the cathode or by passing an alternating current through the aluminum substrate surface as the cathode; a method in which an aqueous alkali solution having a concentration of 10 to 200 g/L is contacted with the surface of the aluminum substrate at 40 to 50°C for 15 to 60 seconds, following which an aqueous solution of nitric acid having a concentration of 100 to 500 g/L is contacted with the surface and thereby neutralized; a method in which an emulsion prepared by mixing a surfactant, water and the like into an oil such as gas oil or kerosene is contacted with the surface of the aluminum substrate at a temperature of from ambient temperature to 50°C, following which the surface is rinsed with water (emulsion degreasing method); and a method in which a mixed solution of, for example, sodium carbonate, phosphates and surfactant is contacted with the surface of the aluminum substrate at a temperature of from ambient temperature to 50°C for 30 to 180 seconds, following which the surface is rinsed with water (phosphate method).

Of these, the organic solvent method, surfactant method, emulsion degreasing method and phosphate method are preferred from the standpoint of removing grease from the aluminum substrate surface while causing substantially no aluminum dissolution.

Known degreasers may be used in degreasing treatment. For example, degreasing treatment may be carried out using any of various commercially available degreasers by the prescribed method.

[Mirror-Like Finishing Treatment]

Mirror-like finishing treatment is carried out to eliminate surface topographic features of the aluminum substrate (e.g., rolling streaks formed during rolling of the aluminum substrate) and improve the uniformity and reproducibility of sealing treatment to be described later.

Mirror-like finishing treatment is not subject to any particular limitation, and may be carried out using any suitable method known in the art. Examples of suitable methods include mechanical polishing, chemical polishing, and electrolytic polishing.

Illustrative examples of suitable mechanical polishing methods include polishing with various commercial abrasive cloths, and methods that combine the use of various commercial abrasives (e.g., diamond, alumina) with buffing. More specifically, a method which is carried out with an abrasive while changing over time the abrasive used from one having coarser particles to one having finer particles is appropriately illustrated. In such a case, the final abrasive used is preferably one having a grit size of 1500. The total reflectivity on the surface of the aluminum substrate in the visible light region (with a wavelength of 300 to 800 nm) can be thus adjusted to 80% or more.

Examples of chemical polishing methods include various methods mentioned in the 6th edition of Aluminum Handbook (Japan Aluminum Association, 2001), pp. 164-165.

Preferred examples include phosphoric acid/nitric acid method, Alupol I method, Alupol V method, Alcoa R5 method, $H_3PO_4$-$CH_3COOH$-Cu method and $H_3PO_4$-$HNO_3$-$CH_3COOH$ method. Of these, the phosphoric acid/nitric acid method, the $H_3PO_4$-$CH_3COOH$-Cu method and the $H_3PO_4$-$HNO_3$-$CH_3COOH$ method are especially preferred.

The total reflectivity on the surface of the aluminum substrate in the visible light region (wavelength: 300 to 800 nm) can be thus adjusted to 80% or more by chemical polishing.

Examples of electrolytic polishing methods include various methods mentioned in the 6th edition of Aluminum Handbook (Japan Aluminum Association, 2001), pp. 164-165; the method described in US 2,708,655; and the method described in Jitsumu Hyomen Gijutsu (Practice of Surface Technology), Vol. 33, No. 3, pp. 32-38 (1986).

The total reflectivity on the surface of the aluminum substrate in the visible light region (wavelength: 300 to 800 nm) can be thus adjusted to 80% or more by electrolytic polishing.

These methods may be suitably combined and used. In an illustrative method that may be preferably used, mechanical polishing which is carried out by changing the abrasive over time from one having coarser particles to one having finer particles is followed by electrolytic polishing.

Mirror-like finishing treatment enables a surface having, for example, a mean surface roughness $R_a$ of 0.1 $\mu$m or less and a total reflectivity of at least 80% to be obtained. The mean surface roughness $R_a$ is preferably 0.03 $\mu$m or less, and more preferably 0.02 $\mu$m or less. The total reflectivity is preferably at least 85%, and more preferably at least 90%.

<Surface Roughening Treatment>

As described above, surface roughening treatment is carried out for the purpose of forming a light scattering surface depending on the intended use of the LED material to be mounted on the insulating substrate of the invention. Surface roughening treatment can be carried out, for example, by a method described in paragraphs [0046] to [0076] of JP 2007-245116 A while appropriately adjusting the specular reflectance to a desired value.

Also in cases where surface roughening treatment is carried out, the total reflectivity in the visible light range is preferably at least 80% and more preferably at least 90%. The specular reflectance is preferably up to 20%, and more preferably up to 10%.

[Insulation Layer]

The insulation layer making up the insulating substrate of the invention is a layer formed at the surface of the aluminum substrate and includes an aluminum anodized film having micropores in part thereof in the depth direction. The insulation layer may include an anodized film of an aluminum substrate different from the foregoing aluminum substrate but preferably includes an anodized film formed on the aluminum substrate by subjecting part of the aluminum substrate to anodizing treatment to be described later in terms of preventing formation defects of the insulation layer.

In the practice of the invention, the degree of ordering of micropores as defined by formula (i) is preferably at least 20%, more preferably at least 40% and most preferably at least 70%.

A degree of ordering of micropores within the foregoing range improves the total reflection properties of the insulating substrate of the invention and the luminance of the white LED light-emitting device of the invention.

$$\texttt{Degree of ordering (\%) = B/A × 100  (i)}$$

In formula (i), A represents the total number of micropores in a measurement region, and B represents the number of specific micropores in the measurement region for which, when a circle is drawn so as to be centered on the center of gravity of a specific micropore and so as to be of the smallest radius that is internally tangent to the edge of another micropore, the circle includes centers of gravity of six micropores other than the specific micropore.

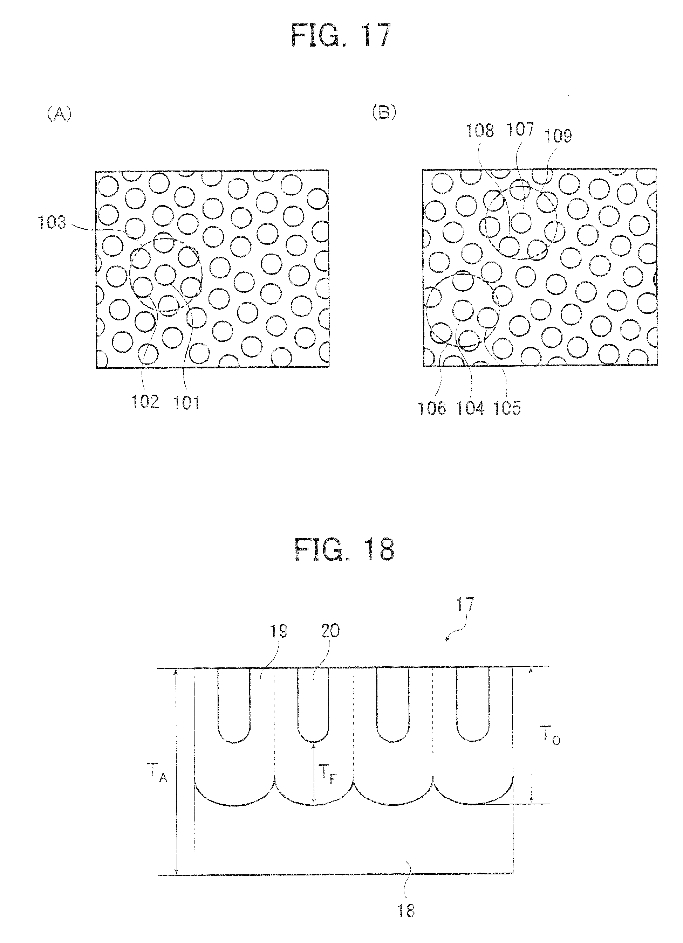

FIG. 17 illustrates a method for computing the degree of ordering of micropores. Above formula (i) is explained more fully below by reference to FIG. 17.

In the case of a first micropore 101 shown in FIG. 17(A), when a circle 103 is drawn so as to be centered on the center of gravity of the first micropore 101 and so as to be of the smallest radius that is internally tangent to the edge of another micropore (inscribed in a second micropore 102), the interior of the circle 3 includes the centers of six micropores other than the first micropore 101. Therefore, the first micropore 101 is included in B.

In the case of another first micropore 104 shown in FIG. 17(B), when a circle 106 is drawn so as to be centered on the center of gravity of the first micropore 104 and so as to be of the smallest radius that is internally tangent to the edge of another micropore (inscribed in a second micropore 105), the interior of the circle 106 includes the centers of gravity of five micropores other than the first micropore 104. Therefore, the first micropore 104 is not included in B.

In the case of yet another first micropore 107 shown in FIG. 17(B), when a circle 109 is drawn so as to be centered on the center of gravity of the first micropore 107 and so as to be of the smallest radius that is internally tangent to the edge of another micropore (inscribed in a second micropore 108), the interior of the circle 109 includes the centers of gravity of seven micropores other than the first micropore 107. Therefore, the first micropore 107 is not included in B.

The insulating substrate of the invention is one having the above-described aluminum substrate and the above-described insulation layer formed at the surface of the aluminum substrate.

The insulating substrate of the invention has an insulating substrate thickness ($T_A$) of up to 1,500 $\mu$m, an anodized film thickness ($T_O$) of at least 5 $\mu$m and a ratio ($T_A/T_O$) of the insulating substrate thickness ($T_A$) to the anodized film thickness ($T_O$) of 2.5 to 300.

In addition, in the insulating substrate of the invention, of the thicknesses of the anodized film in the depth direction, the thickness ($T_F$) of the portion where no micropore is formed is at least 30 nm.

As shown in FIG. 18, the insulating substrate thickness ($T_A$) is the total thickness of the aluminum substrate 18 and the insulation layer 19, the anodized film thickness ($T_O$) is the thickness of the insulation layer 19, and the thickness ($T_F$) of the portion of the anodized film in the depth direction where no micropore is formed is the thickness obtained by subtracting the depth of the micropores 20 from the thickness of the insulation layer 19.

The thickness ($T_A$) can be directly measured with a contact type film thickness meter or by observation of the fracture surface with FE-SEM, the thickness ($T_O$) can be measured with an eddy current film thickness meter or by observation of the fracture surface with FE-SEM, and the thickness ($T_F$) can be measured by observation of the fracture surface with FE-SEM.

By using the insulating substrate of the invention in which the insulating substrate thickness ($T_A$), the anodized film thickness ($T_O$) and the thickness ($T_F$) of the portion of the anodized film in the depth direction where no micropore is formed fall within the foregoing ranges, a light-emitting device having excellent insulation properties and heat dissipation properties and improved white light emission power can be provided.

As can be estimated from the results in Examples to be referred to later, a good balance is achieved between the thickness ($T_O$) and the thickness ($T_A$) to enhance the heat dissipation properties and the thickness ($T_F$) improves the withstand voltage to enhance the insulation properties.

Therefore, the insulating substrate of the invention is preferably used as the substrate to be provided on the side of the LED light-emitting device on which the light emission is observed.

When the thickness ($T_A$) is larger than the above value, the substrate is too large and therefore this case is not preferable in terms of the compactness upon mounting of an LED, through-hole formability for interconnect formation and routing workability upon formation of chips from the substrate.

A thickness ($T_O$) smaller than the above value is not preferable in terms of lowered insulation properties of the substrate. A ratio ($T_A/T_O$) of the thickness ($T_A$) to the thickness ($T_O$) exceeding the above range is not preferable in terms of the through-hole formability and the routing workability because the aluminum substrate is relatively thickened. On the other hand, a ratio ($T_A/T_O$) of the thickness ($T_A$) to the thickness ($T_O$) below the above range is also not preferable because the aluminum portion is relatively thinned and heat generated from the LED to be mounted is less likely to be released.

A thickness ($T_F$) smaller than the above value is not preferable in terms of lowered insulation properties of the substrate.

In the practice of the invention, it is preferable for the insulating substrate to have a thickness ($T_A$) of 1,000 $\mu$m or less, for the anodized film to have a thickness ($T_O$) of 5 $\mu$m or more, and for the ratio ($T_A/T_O$) of the thickness ($T_A$) of the insulating substrate to the thickness ($T_O$) of the anodized film to be from 4 to 250 because the insulation properties and the heat dissipation properties are enhanced and the white light emission power can be further improved.

For the same reason as above, it is more preferable for the insulating substrate to have a thickness ($T_A$) of 800 $\mu$m or less, for the anodized film to have a thickness ($T_O$) of 5 $\mu$m or more, and for the ratio ($T_A/T_O$) of the thickness ($T_A$) of the insulating substrate to the thickness ($T_O$) of the anodized film to be from 5 to 160.

In addition, because the insulation properties are extremely good, it is most preferable for the anodized film to have a thickness ($T_O$) of 20 to 70 $\mu$m, and for the ratio ($T_A/T_O$) of the thickness ($T_A$) of the insulating substrate to the thickness ($T_O$) of the anodized film to be from 8 to 12.

In the practice of the invention, of the thicknesses of the anodized film in the depth direction, the thickness ($T_F$) of the portions where no micropore is formed is preferably 100 nm or more, more preferably 200 nm or more and most preferably 300 nm or more because the insulation properties are enhanced and the defects of the anodized film can be repaired.

On the other hand, the upper limit of the thickness ($T_F$) is preferably 1,500 nm or less, more preferably 1,200 nm and even more preferably 1,000 nm or less because the shape of the anodized film formed in the first anodizing treatment step can be retained even in the second anodizing treatment step shown in the insulating substrate-manufacturing method of the invention to be described later.

[Insulating Substrate-Manufacturing Method]

The method of manufacturing the insulating substrate of the invention is described below in detail.
The insulating substrate-manufacturing method of the invention is a method of manufacturing the above-described insulating substrate of the invention, and includes:

> a first anodizing treatment step for anodizing part of the aluminum substrate to form the aluminum anodized film having the micropores on the aluminum substrate; and
> a second anodizing treatment step which follows the first anodizing treatment step and in which an electrolytic solution at a pH of 2.5 to 11.5 is used to carry out anodizing treatment to seal part of the interior of each of the micropores with aluminum oxide from the bottom direction.

Next, the first anodizing treatment step and the second anodizing treatment step are described.

[First Anodizing Treatment Step]

The first anodizing treatment step is a treatment step for anodizing the aluminum substrate to form a micropore-bearing insulation layer having porous or non-porous portions at the surface of the aluminum substrate.
Anodizing treatment in the first anodizing treatment step can be performed by a conventional method used in the manufacture of a lithographic printing plate support.
More specifically, sulfuric acid, phosphoric acid, chromic acid, oxalic acid, sulfamic acid, benzenesulfonic acid, amidosulfonic acid, malonic acid, citric acid, tartaric acid and boric acid may be used alone or in combination of two or more for the solution for use in anodizing treatment.
It is acceptable for at least ingredients ordinarily present in the aluminum substrate, electrodes, tap water, groundwater and the like to be present in the electrolytic solution. In addition, secondary and tertiary ingredients may be added. Here, "secondary and tertiary ingredients" includes, for example, the ions of metals such as Na, K, Mg, Li, Ca, Ti, Al, V, Cr, Mn, Fe, Co, Ni, Cu and Zn; cations such as ammonium ion; and anions such as nitrate ion, carbonate ion, chloride ion, phosphate ion, fluoride ion, sulfite ion, titanate ion, silicate ion and borate ion. These may be present in concentrations of about 0 to 10,000 ppm.
The anodizing treatment conditions in the first anodizing treatment step vary depending on the electrolytic solution used and thus cannot be strictly specified. However, it is generally suitable for the solution to have an electrolyte concentration of 1 to 80 wt% and a temperature of 5 to 70°C, and for the current density to be 0.5 to 60 A/dm$^2$, the voltage to be 1 to 100 V, and the electrolysis time to be 15 seconds to 50 minutes. These conditions may be adjusted to obtain the desired anodized film weight.
In addition, methods that may be used to carry out anodizing treatment in the first anodizing treatment step include those described in JP 54-81133 A, JP 57-47894 A, JP 57-51289 A, JP 57-51290 A, JP 57-54300 A, JP 57-136596 A, JP 58-107498 A, JP 60-200256 A, JP 62-136596 A, JP 63-176494 A, JP 4-176897 A, JP 4-280997 A, JP 6-207299 A, JP 5-24377 A, JP 5-32083 A, JP 5-125597 A and JP 5-195291 A.
Of these, as described in JP 54-12853 A and JP 48-45303 A, it is preferable to use a sulfuric acid solution as the electrolytic solution. The electrolytic solution has a sulfuric acid concentration of preferably 10 to 300 g/L, and has an aluminum ion concentration of preferably 1 to 25 g/L, and more preferably 2 to 10 g/L. Such an electrolytic solution can be prepared by adding a compound such as aluminum sulfate to dilute sulfuric acid having a sulfuric acid concentration of 50 to 200 g/L.
When anodizing treatment is carried out in the sulfuric acid-containing electrolytic solution in the first anodizing treatment step, direct current or alternating current may be applied across the aluminum substrate and the counter electrode.
When a direct current is applied to the aluminum substrate, the current density is preferably from 1 to 60 A/dm$^2$, and more preferably from 5 to 40 A/dm$^2$.
To keep burnt deposits from arising on portions of the aluminum substrate due to the concentration of current when anodizing treatment in the first anodizing treatment step is carried out as a continuous process, it is preferable to apply current at a low density of 5 to 10 A/dm$^2$ at the start of anodizing treatment and to increase the current density to 30 to 50 A/dm$^2$ or more as anodizing treatment proceeds. When anodizing treatment is carried out as a continuous process, this is preferably done using a system that supplies power to the aluminum substrate through the electrolytic solution.
When the anodized film is porous, the micropores have an average pore size of about 5 to about 1,000 nm and an average pore density of about $1 \times 10^6$ to about $1 \times 10^{10}$ pcs/mm$^2$.
The thickness of the anodized film is preferably 5 to 75 $\mu$m. A film thickness of less than 5 $\mu$m reduces the withstand voltage due to poor insulation properties, whereas a film thickness in excess of 75 $\mu$m reduces the total

reflectivity and is disadvantageous. The thickness of the anodized film is more preferably from 10 to 50 μm.

Examples of electrolysis apparatuses that may be used in anodizing treatment include those described in JP 48-26638 A, JP 47-18739 A and JP 58-24517 B. An apparatus shown in FIG. 12 is particularly used with advantage.

Anodizing treatment in the first anodizing treatment step may be performed under a single processing condition but when the shape of the anodized film such as the shape at a specific position or the shape in the depth direction is to be controlled, anodizing treatments under two or more different conditions may be performed in combination.

On the other hand, a conventionally known method may be used for the anodizing treatment performed to increase the degree of ordering of micropores but self-ordering anodizing treatment described in, for example, JP 3,714,507 B, JP 2002-285382 A, JP 2006-124827 A, JP 2007-231339 A, JP 2007-231405 A, JP 2007-231340 A, JP 2007-231340 A, and JP 2007-238988 A is preferable in terms of the independence of the micropores.

In addition, the methods described in, for example, JP 2008-063643 A and JP 2008-156705 A are preferably used to form micropores having a substantially straight tubular shape in the depth direction.

These treatments are preferably those described under the treatment conditions in the foregoing patent and published patent applications.

Other processes for forming micropores at the surface of the aluminum substrate include, for example, processes which use imprinting (transfer processes and press patterning processes in which a substrate or roll having projections thereon is pressed against the aluminum substrate to form pits in the substrate). A specific example is a process in which a substrate having numerous projections on a surface thereof is pressed against the aluminum substrate surface, thereby forming pits. For example, the process described in JP 10-121292 A may be used.

Another example is a process in which polystyrene spheres are densely arranged on the surface of the aluminum substrate, $SiO_2$ is vapor-deposited onto the spheres, then the polystyrene spheres are removed and the substrate is etched using the vapor-deposited $SiO_2$ as the mask, thereby forming pits.

Another exemplary process is a particle beam process. In a particle beam process, pits are formed by irradiating the surface of the aluminum substrate with a particle beam. This process has the advantage that the positions of the pits can be controlled as desired.

Examples of the particle beam include a charged particle beam, a focused ion beam (FIB), and an electron beam.

For example, the process described in JP 2001-105400 A may be used as the particle beam process.

A block copolymer process may also be used. The block copolymer process involves forming a block copolymer layer on the surface of the aluminum substrate, forming an islands-in-the-sea structure in the block copolymer layer by thermal annealing, then removing the island components to form pits. For example, the process described in JP 2003-129288 A may be used as the block copolymer method.

A resist patterning/exposure/etching process may also be used. In a resist patterning/exposure/etching process, resist on the surface of an aluminum substrate is exposed and developed by photolithography or electron beam lithography to form a resist pattern. The resist is then etched, forming pits which pass entirely through the resist to the surface of the aluminum substrate.

In the case of using such processes as imprinting process, particle beam process, block copolymer process and resist patterning/exposure/etching process, these treatments for giving starting points for electrolysis to the aluminum substrate surface are followed by anodizing treatment to enable a micropore-bearing anodized film to be formed.

In the case of using such processes as imprinting process, particle beam process, block copolymer process and resist patterning/exposure/etching process, the method described in JP 2008-156716 A is preferably used to form micropores having a substantially straight tubular shape in the depth direction.

[Second Anodizing Treatment Step]

The second anodizing treatment step is a treatment step which follows the first anodizing treatment step and in which anodizing treatment is performed with an electrolytic solution at a pH of 2.5 to 11.5 to seal part of the interior of the micropores with aluminum oxide from the direction of the bottom, and of the thicknesses in the depth direction of the anodized film in the insulating substrate of the invention, the thickness ($T_F$) of the portions where no micropore is formed can be adjusted to 30 nm or more by this step.

Anodizing treatment in the second anodizing treatment step is carried out with an electrolytic solution having a pH of 2.5 to 11.5 around the neutral range.

Examples of the acid that may be used in an electrolytic solution having a pH around the neutral range include, as in the first anodizing treatment step, sulfuric acid, phosphoric acid, chromic acid, oxalic acid, sulfamic acid, benzenesulfonic acid, amidosulfonic acid, malonic acid, citric acid, tartaric acid and boric acid. Boric acid is preferably used because it exhibits neutral characteristics even if the concentration of the electrolytic solution is increased in terms of the current density in anodizing treatment and the anodized film formed by the first anodizing treatment step is not readily dissolved out.

Basically as in the first anodizing treatment, the anodizing treatment conditions in the second anodizing treatment step vary depending on the electrolytic solution used and thus cannot be strictly specified. However, because of the use of an electrolytic solution having a pH around the neutral range, it is suitable for the solution to have an electrolyte concentration of 1 to 40 wt% and a temperature of 1 to 70°C, and for the current density to be 0.05 to 30 A/dm$^2$, the voltage to be 1 to 1,000 V, and the electrolysis time to be 5 seconds to 60 minutes. These conditions may be adjusted to obtain the desired anodized film weight.

<Sealing Treatment>

In the insulating substrate-manufacturing method of the invention, if necessary, sealing treatment may be performed to close the micropores present in the anodized film when it is porous.

Sealing treatment may be performed in accordance with a known method, such as boiling water treatment, hot water treatment, steam treatment, sodium silicate treatment, nitrite treatment or ammonium acetate treatment. For example, sealing treatment may be performed using the apparatuses and processes described in JP 56-12518 B, JP 4-4194 A, JP 5-202496 A and JP 5-179482 A.

In the practice of the invention, when the micropores are sealed by such sealing treatment, of the thicknesses of the anodized film in the depth direction, the thickness ($T_F$) of the portions where no micropore is formed is calculated based on the bottom of the micropores before sealing treatment (depth of the micropores).

[Rinsing with Water]

In the insulating substrate-manufacturing method of the invention, rinsing with water is preferably carried out after the end of each of the treatment steps. Examples of the water used for rinsing include pure water, well water and tap water. A nip device may be used to prevent the treatment solution from being carried into the subsequent step.

[Other Treatments]

In addition, according to the insulating substrate-manufacturing method of the invention, various treatments may optionally be carried out on the surface of the insulating substrate.

For example, an inorganic insulation layer made of a white insulating material (e.g., titanium oxide) or an organic insulation layer such as a white resist may be formed to enhance the whiteness of the reflecting substrate.

The insulation layer made of aluminum oxide may be colored with a desired color other than white, for example, by electrodeposition. Specifically, the insulation layer may be colored by electrolysis in an electrolytic solution containing color-stainable ion species described in, for example, Yokyoku Sanka (Anodization) edited by Metal Finishing Society of Japan, Metal Finishing Course B (1969 pp. 195-207) and Shin Arumaito Riron (New Alumite Theory), Kallos Publishing Co., Ltd. (1997 pp. 95-96), as exemplified by Co ions, Fe ions, Au ions, Pb ions, Ag ions, Se ions, Sn ions, Ni ions, Cu ions, Bi ions, Mo ions, Sb ions, Cd ions and As ions.

In order to further enhance the insulation properties and reflectivity, for example, a layer formed by the sol-gel method as described in paragraphs [0016] to [0035] of JP 6-35174 A may also be provided on the insulation layer made of aluminum oxide.

The sol-gel method is generally a method which involves subjecting a sol made of a metal alkoxide to hydrolysis and polycondensation reaction to form a gel having no fluidity and heating the gel to form an oxide layer (ceramic layer).

The metal alkoxide is not particularly limited but to form a layer with a uniform thickness, examples thereof include Al(O-R)n, Ba(O-R)n, B(O-R)n, Bi(O-R)n, Ca(O-R)n, Fe(O-R)n, Ga(O-R)n, Ge(O-R)n, Hf(O-R)n, In(O-R)n, K(O-R)n, La(O-R)n, Li(O-R)n, Mg(O-R)n, Mo(O-R)n, Na(O-R)n, Nb(O-R)n, Pb(O-R)n, Po(O-R)n, Po(O-R)n, P(O-R)n, Sb(O-R)n, Si(O-R)n, Sn(O-R)n, Sr(O-R)n, Ta(O-R)n, Ti(O-R)n, V(O-R)n, W(O-R)n, Y(O-R)n, Zn(O-R)n, and Zr(O-R)n (where R represents an optionally substituted, linear, branched, or cyclic hydrocarbon group and n represents a natural number).

Of these, Si(O-R)n which is excellent in reactivity with the insulation layer and sol-gel layer formability is more preferable.

In the practice of the invention, the method of forming a sol-gel layer is not particularly limited and a method which involves application and heating of a sol solution is preferable to control the thickness of the layer.

The sol solution preferably has a concentration of 0.1 to 90 wt%, more preferably 1 to 80 wt% and most preferably 5 to 70 wt%.

When forming the sol-gel layer in the invention, its thickness is preferably from 0.01 $\mu$m to 20 $\mu$m, more preferably from 0.05 $\mu$m to 15 $\mu$m, and most preferably from 0.1 $\mu$m to 10 $\mu$m in terms of high reflectivity and insulation properties. A thickness above this range is not preferable in terms of high reflectivity and a thickness below this range is also not preferable in terms of insulation properties. The sol solution may be repeatedly applied to increase the thickness of the layer.

[White LED Light-Emitting Device]

Next, the white LED light-emitting device according to the invention is described in detail.

The white LED light-emitting device of the invention is one including the above-described insulating substrate of the invention, a blue LED light-emitting device provided on top of the insulating substrate on the insulation layer side, and a fluorescent emitter provided at least on top of the blue LED light-emitting device.

The above-described insulating substrate of the invention has no limitation on the shape of the light-emitting device used and the type of the LEDs and may be used in various applications.

Next, the configuration of the white LED light-emitting devices of the invention is described with reference to drawings.

FIG. 19 is a schematic cross-sectional view illustrating a preferable example of the white LED light-emitting device of the invention.

A white LED light-emitting device 200 shown in FIG. 19 is configured as a phosphor color mixed type, white LED light-emitting device, and includes an insulating substrate 230 having an insulation layer 232 and an aluminum substrate 233, a blue LED light-emitting device 222 provided on top of the insulating substrate 230 on the side of the insulation layer 232, and a fluorescent emitter 226 provided at least on top of the blue LED light-emitting device 222.

As shown in FIG. 19, in the white LED light-emitting device of the invention, the blue LED light-emitting device 222 is preferably sealed with a resin 224.

In the practice of the invention, fluorescence emission units described in Japanese Patent Application Nos. 2009-134007 and 2009-139261 may be used for the fluorescent emitter 226.

FIG. 20 is a schematic cross-sectional view illustrating a preferable example of a known white LED light-emitting device as described in the section of BACKGROUND ART but the white LED light-emitting device of the invention can be obtained by replacing the substrate 340 shown in FIG. 20 by the insulating substrate of the invention.

EXAMPLES

The first aspect of the invention is described below more specifically by way of examples. However, the invention should not be construed as being limited to the following examples.

(Example I-1)

An aluminum substrate with an aluminum purity of 99.95 wt% (manufactured by Nippon Light Metal Co., Ltd.; thickness: 0.4 mm) was drilled to form through-holes (hole diameter: 0.2 mm) and routed so that individual chips can be obtained.

Next, this aluminum substrate was anodized with a sulfuric acid electrolytic solution (sulfuric acid concentration: 50 g/l) for 1 hour under conditions including a voltage of 25 V, a solution temperature of 15°C and a solution flow velocity of 3.0 m/min to thereby obtain an insulating substrate, the entire surface of which is coated with a uniform anodized film with a thickness of 10 $\mu$m.

(Example 1-2)

Example I-1 was repeated except that an aluminum substrate with an aluminum purity of 99.99 wt% (manufactured by Nippon Light Metal Co., Ltd.; thickness: 0.4 mm) was used, thereby obtaining an insulating substrate.

(Example I-3)

The same aluminum substrate as used in Example I-1 was first annealed. More specifically, the aluminum substrate was annealed in an annealing furnace at 400°C for 12 hours and then directly put into water for quenching.

Then, the annealed aluminum substrate was treated in the same manner as in Example I-1 to form through-holes and routed so that individual chips can be obtained.

The subsequent anodizing treatment was carried out in the same manner as in Example I-1 to obtain an insulating substrate.

(Example I-4)

Example I-2 was repeated except that a sulfuric acid electrolytic solution was used in anodizing treatment at a sulfuric acid concentration of 30 g/l, thereby obtaining an insulating substrate.

(Example I-5)

In the resulting insulating substrate in Example I-4, the interior of the pores in the anodized film was only filled with an electrolytic solution containing 0.5 M boric acid and 0.05 M sodium borate up to a depth of 1 $\mu$m, and the insulating substrate was further anodized at a voltage of 400 V and a solution temperature of 40°C for 10 minutes to thereby perform Example I-5.

(Comparative Example I-1)

The same aluminum substrate as used in Example I-1 was first anodized in the same manner as in Example I-1. Then, the aluminum substrate was treated in the same manner as in Example I-1 to form through-holes (hole diameter: 0.2 mm) and routed so that individual chips can be obtained.

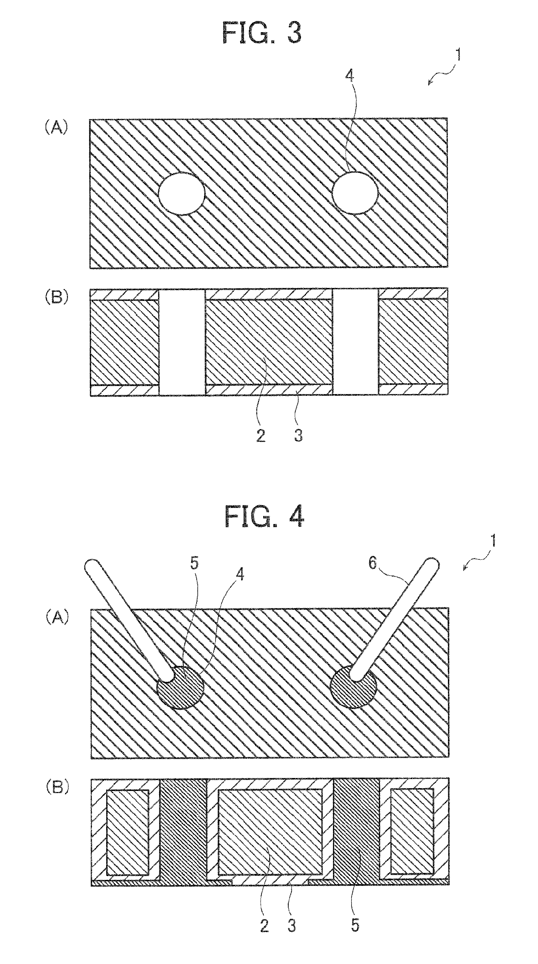

FIG. 3 shows schematic views illustrating the insulating substrate in Comparative Example I-1, (A) being a plan view and (B) being a cross-sectional view. In the insulating substrate 1 in Comparative example I-1, through-holes 4 are formed after anodizing treatment and therefore the inner wall surfaces of the through holes 4 are not coated with the anodized film 3 as shown in FIG. 3.

(Comparative Example I-2)

Example I-1 was repeated except that a sulfuric acid electrolytic solution was used in anodizing treatment at a sulfuric acid concentration of 300 g/l, thereby obtaining an insulating substrate.

<Measurement of Number of Intermetallic Compound Particles>

The number (pcs/mm$^3$) of intermetallic compound particles with a circle equivalent diameter of 1 $\mu$m or more which were present in the anodized film of the insulating substrate in each of the above examples was measured by the above-described observation method using FE-SEM. The results are shown in Table 1.

<Withstand Voltage>

The withstand voltage of the insulating substrate in each of the above examples was measured according to JIS C2110-1994. The results are shown in Table 1.

<Continuity Test>

FIG. 4 shows schematic views illustrating the state in the continuity test, (A) being a plan view and (B) being a cross-sectional view. In the insulating substrate 1 in each of the examples, as shown in FIG. 1, a pair of through-holes 4 were filled with a copper interconnection 5 and electrodes 6 of an insulation resistance tester (megohmmeter) were brought into contact with the copper interconnection 5 to confirm the continuity with a voltage applied. The results are shown in Table 1.

A sample in which no breakdown occurred even if a maximum voltage of 250 V was applied and no leak to other electrode was observed was rated "good" and a sample in which insulation was not maintained but continuity was established by application of a voltage was rated "poor."

[Table 1]

| Continuity test | Example I | | | | | Comparative Example I | |
|---|---|---|---|---|---|---|---|
| | 1 | 2 | 3 | 4 | 5 | 1 | 2 |
| Aluminum purity [wt%] | 99.95 | 99. 99 | 99.95 | 99.99 | 99.99 | 99.95 | 99.95 |
| Annealing treatment | Unperformed | Unperformed | Performed | Unperformed | Unperformed | Unperformed | Unperformed |
| Sulfuric acid concentration [g/l] | 50 | 50 | 50 | 30 | 30 | 50 | 300 |
| Additional treatment with boric acid | Unperformed | Unperformed | Unperformed | Unperformed | Performed | Unperformed | Unperformed |
| Number of intermetallic compound particles [pcs/mm$^3$] | 1300 | 600 | 700 | 150 | 100 | — | 3200 |
| Withstand voltage [V] | 890 | 980 | 950 | 1130 | 1200 | — | 240 |
| Continuity test | Good | Good | Good | Good | Good | Poor | Poor |

The results shown in Table 1 revealed that the insulating substrates in Examples I-1 to I-5 in which the anodized film contains intermetallic compound particles with a circle equivalent diameter of 1 $\mu$m or more in an amount of up to 2,000 pcs/mm$^3$ had high withstand voltage and good insulation properties.

It was also revealed that Example I-2 which used the aluminum substrate with an aluminum purity of 99.99 wt% showed the reduction in the number of intermetallic compound particles, an increased withstand voltage and better insulation properties, as compared with Example I-1 in which the aluminum purity was 99.95 wt%.

It was also revealed that Example I-3 in which the aluminum substrate was annealed showed the reduction in the number of intermetallic compound particles, an increased withstand voltage and better insulation properties, as compared with Example I-1 in which no annealing treatment was carried out.

It was also revealed that Example I-4 which used the electrolytic solution in anodizing treatment at the sulfuric acid concentration of 30 g/l showed the reduction in the number of intermetallic compound particles, an increased withstand voltage and better insulation properties, as compared with Example I-2 in which the sulfuric acid concentration was 50 g/l.

It was also revealed that Example 1-5 in which additional boric acid treatment was carried out showed the reduction in the number of intermetallic compound particles, an increased withstand voltage and better insulation properties, as compared with Example I-4 in which this treatment was not carried out.

In contrast, it was revealed that in Comparative Example I-1 in which the inner wall surfaces of the through-holes were not coated with the anodized film, breakdown occurred in the continuity test and insulation properties were not ensured.

It was also revealed that Comparative Example I-2 in which the anodized film contained intermetallic compound particles with a circle equivalent diameter of 1 $\mu$m or more in an amount of 3,200 pcs/mm$^3$ showed low withstand voltage and poor insulation properties.

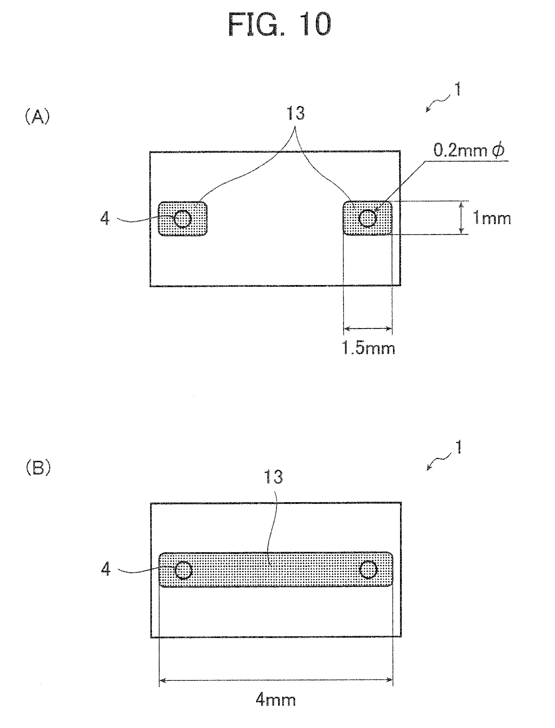

Next, an interconnection was formed according to an interconnection pattern shown in FIG. 10 in the insulating substrate in Example I-2 by the first to fourth interconnection forming methods as described above. FIG. 10 shows schematic views illustrating the interconnection pattern, (A) being a plan view and (B) being a bottom view. FIG. 10 shows the interconnection pattern 13.

(Example I-6)

Gold nanoparticles (NanoTek available from C. I. Kasei Co., Ltd.; 50 g) were added to 50 g of xylene and the mixture was stirred at room temperature for 8 hours to obtain a stabilized gold ink dispersion. The solid powder analysis of the ink dispersion revealed that the gold content was 26.8 wt%. A silane coupling agent KBM603 (Shin-Etsu Polymer Co., Ltd.) was further added to the ink dispersion in an amount of 2 wt% with respect to the ink dispersion and mixed to prepare a metal ink. The prepared metal ink had a viscosity of 10 cps.

Then, a Dimatix Material Printer DMP-2831 (FUJIFILM Dimatix, Inc.) was used to apply the prepared metal ink by ink-jet printing onto the insulating substrate in Example I-2 according to the interconnection pattern shown in FIG. 10, and the metal ink was hot-air dried in a hot air dryer set at 160°C for about 5 minutes to obtain a gold metal interconnection.

(Example I-7)

A screen printer (TU2030-B manufactured by Seritech Co., Ltd.) was used to apply the metal ink prepared in the same manner as in Example I-6 by screen printing onto the insulating substrate in Example 1-2 according to the interconnection pattern shown in FIG. 10, and the metal ink was hot-air dried in a hot air dryer set at 160°C for about 5 minutes to obtain a gold metal interconnection.

(Example I-8)

The insulating substrate in Example I-2 was immersed in a resist solution (DSR330P available from Tamura Kaken Corporation) at 25°C for 5 minutes, dried at 80°C for 10 minutes, exposed using an exposure apparatus (FL-3S manufactured by Ushio Lighting, Inc.) and a mask having an interconnection pattern shown in FIG. 10 formed therein, and developed with a 1 wt% aqueous solution of sodium carbonate at 30°C for 90 seconds to remove unnecessary resist portions.

Next, the insulating substrate from which the unnecessary resist portions had been removed was immersed in a copper electroless plating solution (MK-460 thick layer type, cyanide free copper electroless plating solution available from Muromachi Chemical Inc.) for 20 minutes to obtain an interconnection.

(Example I-9)

One gram of palladium chloride (8071100001 available from Merck) was added dropwise to a dilution obtained by diluting 10 g of γ-mercaptopropyltrimethoxysilane (KBM803 available from Shin-Etsu Chemical Co., Ltd.) as the silane coupling agent with 80 g of methanol to make palladium attached to mercapto group in the silane coupling agent. The mixture was left to stand for 8 hours to obtain ink (treatment solution).

A Dimatix Material Printer DMP-2831 (FUJIFILM Dimatix, Inc.) was used to apply the resulting ink by ink-jet printing onto the insulating substrate in Example I-2 according to the interconnection pattern shown in FIG. 10, and the ink was hot-air dried in a hot air dryer set at 160°C for about 5 minutes to obtain a metal-reducing layer.

Next, the insulating substrate having the metal-reducing layer formed thereon was immersed in a copper electroless plating solution (MK-460 thick layer type, cyanide free copper electroless plating solution available from Muromachi Chemical Inc.) for 20 minutes to obtain an interconnection.

The interconnections obtained in Examples I-6 to 1-9 were brought into contact with the electrodes of the insulation resistance tester and as a result continuity was confirmed by application of a voltage of 3 V and they were found to have sufficient practical utility.

Next, the second aspect of the invention is described more specifically by way of examples. However, the invention should not be construed as being limited to the following examples.

(Examples II-1 to II-8)

<Preparation of Aluminum Substrate>

An aluminum alloy containing 0.06 wt% of Si, 0.30 wt% of Fe, 0.005 wt% of Cu, 0.001 wt% of Mn, 0.001 wt% of Mg, 0.001 wt% of Zn and 0.03 wt% of Ti, with the balance being Al and inevitable impurities was used to prepare a melt. The melt was subjected to melt treatment and filtration and an ingot with a thickness of 500 mm and a width of 1,200 mm was prepared by DC casting.

Next, the ingot surface was scalped by a scalping machine to a depth of, on average, 10 mm and the ingot was then held at a soaking temperature of 550°C for about 5 hours. When the temperature dropped to 400°C, the ingot was rolled using a hot rolling mill into a 2.7 mm-thick rolled plate.

The rolled plate was further heat-treated at 500°C using a continuous annealing machine and finished to a thickness of 0.24 mm by cold rolling to thereby obtain an aluminum substrate of JIS 1050.

The aluminum substrate was cut to a width of 1,030 mm and subjected to anodizing treatment and sealing treatment to be described later.

<Anodizing Treatment>

An anodizing apparatus of the configuration shown in FIG. 12 was used to anodize the aluminum substrates obtained as above. The electrolytic solution conditions, the voltage and the thickness of the anodized films formed are shown in Table 2. The thickness of the anodized films was determined by observing it from the cross-sectional direction by SEM at a magnification of 1,000X to 5,000X.

<Sealing Treatment>

The thus obtained insulation layer including the anodized film was subjected to one of sealing treatments (1) to (6) described below to prepare an insulating substrate. The type of sealing treatment carried out in each of the examples is as shown in Table 2.

Sealing Treatment (1):

The aluminum substrate having the insulation layer including the anodized film was immersed in pure water at 80°C for 1 minute and then heated in an atmosphere at 110°C for 10 minutes with the substrate kept immersed.

Sealing Treatment (2):

The aluminum substrate having the insulation layer including the anodized film was immersed in pure water at 60°C for 1 minute and then heated in an atmosphere at 130°C for 25 minutes with the substrate kept immersed.

Sealing Treatment (3):

The aluminum substrate having the insulation layer including the anodized film was immersed in a 5% aqueous solution of lithium chloride at 80°C for 1 minute and then heated in an atmosphere at 110°C for 10 minutes with the substrate kept immersed.

Sealing Treatment (4):

The aluminum substrate having the insulation layer including the anodized film was exposed to water vapor at 100°C and 500 kPa for 1 minute.

Sealing Treatment (5):

The aluminum substrate having the insulation layer including the anodized film was immersed in treatment solution A (see below) at 25°C for 15 minutes and then heated in an atmosphere at 500°C for 1 minute.

(Treatment solution A)

```
* Titanium tetraisopropoxide       50.00 g
* Concentrated nitric acid       0.05 g
* Pure water       21.60 g
* Methanol       10.80 g
```

Sealing Treatment (6):

The aluminum substrate having the insulation layer including the anodized film was immersed in treatment solution B (see below) at 25°C for 1 hour.

(Treatment solution B)

```
* Colloidal silica with a diameter of 20 nm (MA-ST-M from Nissan Chemical Industries, Ltd.)       0.01 g
* Ethanol       100.00 g
```

Sealing Treatment (7):

The aluminum substrate having the insulation layer including the anodized film was immersed in treatment solution B (see [0103]) at 25°C for 3 hours.

(Comparative Examples II-1 to II-3)

Insulating substrates in Comparative Examples II-1, 2 and 3 were prepared by the same methods as those in Examples I-1, 3 and 6 except that sealing treatment was not carried out.

<Porosity>

The porosity of the anodized film in each of the prepared insulating substrates was calculated by the following formula. The results are shown in Table 2.

```
Porosity (%) = [ 1 - (density of oxide film / 3.98)] x 100
```

(wherein the density $(g/m^3)$ of the oxide film represents the weight of the oxide film per unit area divided by the thickness of the oxide film, and 3.98 is the density $(g/m^3)$ of aluminum oxide.)

<Thermal Conductivity>

For each of the prepared insulating substrates, TC-9000 laser flash type thermal diffusivity measuring system (ULVAC-RIKO, Inc.) was used to calculate the thermal diffusivity according to the t1/2 process and the thermal conductivity was calculated from the following formula. The results are shown in Table 2.

$$\texttt{Thermal conductivity } \lambda = \alpha \times Cp \times \rho$$

(wherein $\alpha$ represents the thermal diffusivity, Cp represents the specific heat and $\rho$ represents the density.)

<Breakdown Voltage>

The breakdown voltage of the resulting insulating substrates was measured according to JIS C2110 standard. The results are shown in Table 2.

<Measurement of Total Reflectivity>

The total reflectivity of the resulting insulating substrates at 400 to 700 nm was measured using SP64 manufactured by X-Rite, Inc. The measurement was made at intervals of 10 nm and the average of the measurements was calculated. The results are shown in Table 2.
[Table 2]

| Table 2 | | Anodizing treatment | | | | | Sealing treatment | Evaluation of characteristics | | | |
|---|---|---|---|---|---|---|---|---|---|---|---|
| | | Electrolytic solution | Voltage | Temp. | Time | Thickness of anodized film | | Porosity | Thermal conductivity | Withstand voltage | Average total reflectivity (400-700nm) |
| EX II | 1 | 0.3M $H_2SO_4$ | 25V | 17°C | 4.0hr | 25 $\mu$m | (1) | 14% | 91W/mK | 480V | 89% |
| | 2 | 0. 3M $H_2SO_4$ | 25V | 17°C | 4.0hr | 25 $\mu$m | (2) | 5% | 110W/mK | 480V | 89% |
| | 3 | 0.3M $H_2SO_4$ | 25V | 17°C | 8.0hr | 48 $\mu$m | (2) | 5% | 85W/mK | 1100v | 81% |
| | 4 | 1.0M $H_2SO_4$ | 20V | 20°C | 1.0hr | 30 $\mu$m | (3) | 8% | 95W/mK | 520V | 84% |
| | 5 | 5.0M $H_2SO_4$ | 16V | 30°C | 0.5hr | 25 $\mu$m | (4) | 27% | 75W/mK | 475V | 82% |
| | 6 | 0.5M $H_2C_2O_4$ | 40V | 16°C | 8.0hr | 25 $\mu$m | (5) | 8% | 102W/mK | 460V | 74% |
| | 7 | 0.5M NaOH | 20V | 20°C | 4.0hr | 20 $\mu$m | (6) | 11% | 101W/mK | 410V | 80% |
| | 8 | 0.3M $H_2SO_4$ | 25V | 17°C | 4.0hr | 25 $\mu$m | (7) | 5% | 108W/mK | 480V | 88% |
| CE II | 1 | 0.3M $H_2SO_4$ | 25V | 17°C | 4.0hr | 25 $\mu$m | Unperformed | 32% | 65W/mK | 480V | 89% |
| | 2 | 0.3M $H_2SO_4$ | 25V | 17°C | 8.0hr | 48 $\mu$m | Unperformed | 35% | 28W/mK | 1100V | 81% |
| | 3 | 0.5M $H_2C_2O_4$ | 40V | 16°C | 8.0hr | 25 $\mu$m | Unperformed | 36% | 30W/mK | 460V | 74% |

The results shown in Table 2 first revealed that, according to the comparison between Comparative Examples II-1 and II-2, the heat dissipation properties (thermal conductivity) are decreased with increasing thickness of the anodized film in terms of improving the insulation properties (withstand voltage).
In contrast, it was revealed that the insulating substrates in Examples II-1 to II-8 obtained by sealing so that the anodized film has a porosity of 30% or less can suppress the deterioration of the heat dissipation properties even if the anodized film thickness is increased and have also excellent insulation properties and heat dissipation properties.
Particularly, according to the comparison between Example II-1 and Comparative Example II-1 in which the conditions for forming the anodized film and the film thickness values were the same, it was revealed that the thermal conductivity can be improved with the withstand voltage and the average reflectivity maintained, by adjusting the porosity of the anodized film to 30% or less though sealing treatment. The comparison between Example II-3 and Comparative Example II-2 and the comparison between Example II-6 and Comparative Example II-3 also show the same result.

(Example II-9)

The insulating substrate (porosity: 5%) prepared in Example II-3 was further subjected to oxygen plasma treatment while the pressure is controlled, thereby preparing an insulating substrate in Example II-9.
A plasma reactor PR300 (Yamato Scientific Co., Ltd.) was used to carry out oxygen plasma treatment at 100 W for 4 minutes while flowing oxygen at 80 mL/min and adjusting the pressure to -0.1 MPa.
Oxygen plasma treatment causes hydroxyl groups of aluminum hydroxide sealed inside the micropores by sealing treatment to be reacted with ionized oxygen and removed as water. The aluminum hydroxide which was present in the surface layer was converted to aluminum oxide, which was removed by volumetric shrinkage.
As a result of the observation by SEM of the surface of the insulating substrate having undergone oxygen plasma treatment, the change of properties was observed up to about 2 $\mu$m from the surface, and then as a result of the measurement of a 5 $\mu$m square portion by AFM in the tapping mode, it was revealed that pits with an average depth of 1.8 $\mu$m were present at an average pitch of 110 nm. As a result of the measurement by AFM of the surface of the insulating substrate prepared in Example II-3, pits with a depth of more than 0.3 $\mu$m were not observed, nor could clear pitch be detected.
The porosity of the anodized film having undergone oxygen plasma treatment as calculated by the above-described method was 9%.

(Example II-10)

The insulating substrate (porosity: 5%) prepared in Example II-3 was further subjected to alkali treatment with a 1% NaOH solution (solution temperature: 10°C) to prepare an insulating substrate in Example II-10.
The insulating substrate having undergone alkali treatment was rinsed with water for 10 minutes and dried, and then the surface of the insulating substrate was observed by SEM. As a result, the change of properties was observed up to about 10 $\mu$m from the surface. Then, a 5 $\mu$m square portion was measured by AFM in the tapping mode and as a result it was revealed that pits with an average depth of 2 $\mu$m were present at an average pitch of 100 nm.
The porosity of the anodized film having undergone alkali treatment as calculated by the above-described method was 12%.
The thus prepared insulating substrates in Examples II-1 to II-10 and Comparative Examples II-1 to II-3 were subjected to formation of a metal interconnection layer to be used in mounting according to the method described below to thereby prepare interconnection substrates.

(1) Formation of Ni seed layer

First of all, to a 1,000 mL beaker were added 25 g of nickel sulfate hexahydrate and 500 mL of pure water to dissolve the nickel sulfate hexahydrate. Then, 20 g of sodium hypophosphite, 10 g of sodium acetate and 10 g of sodium citrate were added and stirred.
Then, pure water was added to a total amount of 1,000 mL. Thereafter, the mixture was adjusted with sulfuric acid to a pH of 5 and the cell was held at a temperature of 83°C with stirring.
Each of the insulating substrates was immersed in this solution for 1 minute to form an Ni seed layer.

(2) Formation of Cu plated layer

Each substrate having the Ni seed layer formed thereon was immersed in an electrolytic solution prepared from sulfuric acid, copper sulfate, hydrochloric acid, polyethylene glycol and sodium lauryl sulfate and electrolyzed at a constant voltage to form a Cu plated layer with a thickness of 20 $\mu$m.

(3) Formation of metal interconnection

Each substrate having the Cu plated layer formed thereon was immersed in a resist solution (DSR330P available from Tamura Kaken Corporation) at 25°C for an immersion time of 5 minutes. Then, the resist solution was dried at a drying temperature of 80°C for a drying time of 10 minutes.

Then, FL-3S (Ushio Lighting, Inc.) was used to perform exposure with the use of a mask having an interconnection pattern formed therein, and 1% sodium carbonate aqueous solution was used as the developer to perform development at 30°C for 90 seconds to remove unnecessary part of the resist layer.

Then, each substrate having the pattern formed by the above method was immersed in a hydrogen peroxide solution and etched to remove non-interconnected portions of the Cu layer and the Ni seed layer.

Then, the remaining resist layer was removed to prepare an interconnection substrate having a Cu interconnection formed therein.

(4) Formation of Au plated layer

In order to impart wire bonding suitability, the interconnection substrate having the Cu interconnection formed therein was subjected to Ni strike plating and an Au plated layer was further formed on top of the layer formed by Ni strike plating.

Ni strike plating was carried out with a mixed solution of nickel and hydrochloric acid for 5 minutes.

Then, the interconnection substrate was immersed at 50°C for 10 minutes in a solution prepared by adding PRECIOUSFAB ACG2000 base solution and reducing solution (Tanaka Holdings Co., Ltd.) at a ratio of 10:0.4 to form an Au plated layer.

When using the insulating substrates prepared in Comparative Examples II-1 to II-3 in which sealing treatment was not carried out, the underlying Ni seed layer could not be peeled off when removing the non-interconnected portions of the Cu layer by etching in the steps shown in (3) and (4), whereby the reflectivity of the non-interconnected portions was reduced and the entire surface was plated with gold upon the formation of the Au plated layer.

On the other hand, when using the insulating substrates prepared in Examples II-1 to II-8, the problems as described above did not occur but the results obtained showed somewhat poor adhesion to thin line portions of the Cu interconnection formed.

When using the insulating substrates prepared in Examples II-9 and II-10, it was revealed that the problems as described above did not occur and the adhesion to thin line portions of the Cu interconnection formed was also excellent. This is presumably because the anchor effect with the Cu interconnection is generated by the textured shape of the surfaces of the insulating substrates prepared in Examples II-9 and II-10.

(Example II-11)

An ink-jet printer (DMT-2831 manufactured by Dimatix) was used to discharge a water-repellent material (perfluorohexylethylmethoxysilane $[CF_3(CF_2)_5CH_2CH_2Si(OCH_3)_3]$ (Gelest, Inc.) without purification and to adhere it to the insulating substrate prepared in Comparative Example II-2 (unsealed; porosity: 36%) in an interconnection shape. Then, the material was dried.

Thereafter, the same sealing treatment as the above-described sealing treatment (1) was carried out. The porosity of the anodized film as calculated by the above-described method was 18%.

Then, alkali dissolution treatment (1% NaOH solution; solution temperature: 30°C; treatment time: 20 seconds) was carried out to remove a fluorine (fluoroalkylsilane) film which was substantially a single layer.

In this state, Ni was vapor-deposited to form an Ni seed layer on the entire surface.

Subsequently, the steps shown in (2) to (4) above were repeated to prepare a Cu interconnection substrate.

In the sealed non-interconnected portions, the Ni seed layer was easily dissolved out in the step shown in (3) and deposition of metal on the non-interconnected portions was also not observed in Ni strike plating and Au plating carried out in the step shown in (4) above.

Next, the third aspect of the invention is described more specifically by way of examples. However, the invention should not be construed as being limited to the following examples. (Examples III-1 to III-12, Comparative Examples III-1 and III-2)

(1) Pretreatment Step of Aluminum Substrate (Electrolytic Polishing)

A high-purity aluminum substrate (Sumitomo Light Metal Industries, Ltd.; purity, 99.99 wt%; thickness, 0.4 mm) was cut to a size of 10 cm square that allows it to be anodized, then subjected to electrolytic polishing using an electrolytic polishing solution of the composition indicated below at a voltage of 25 V, a solution temperature of 65°C, and a solution flow velocity of 3.0 m/min.

A carbon electrode was used as the cathode, and a GP0110-30R unit (Takasago, Ltd.) was used as the power supply. In addition, the flow velocity of the electrolytic solution was measured using a vortex flow monitor FLM22-10PCW manufactured by As One Corporation.

Electrolytic polishing was not carried out in Example III-8.

[Electrolytic Polishing Solution Composition]

* 85 wt% Phosphoric acid (Wako Pure Chemical Industries, Ltd.)          660 mL
* Pure water          160 mL
* Sulfuric acid          150 mL
* Ethylene glycol          30 mL

(2) First Anodizing Treatment Step (Anodizing Treatment)

First, the aluminum substrate having undergone electrolytic polishing treatment (high-purity aluminum substrate in Example III-8) was subjected to 1 hour of anodizing treatment with an electrolytic solution of 0.30 mol/L sulfuric acid under the following conditions: voltage, 25 V; solution temperature, 15°C; solution flow velocity, 3.0 m/min. In addition, the sample having undergone anodizing treatment was immersed in a mixed aqueous solution of 0.5 mol/L phosphoric acid at 40°C for 20 minutes to perform film removal.

Then, the same treatment as above was repeated by the number of times shown in Table 3 and re-anodizing treatment was carried out in an electrolytic solution containing 0.30 mol/L sulfuric acid under the conditions including a voltage of 25 V, a solution temperature of 15°C and a solution flow velocity of 3.0 m/min, by setting the anodizing time so that the thickness ($T_O$) of the anodized film may be the thickness shown in Table 3. The anodized film was further immersed in a mixed aqueous solution of 0.5 mol/L phosphoric acid at 40°C for 15 minutes to perform film removal, thereby forming at the surface of the aluminum substrate an anodized film having straight tube-shaped micropores arranged in a honeycomb array.

The thickness ($T_O$) of the anodized film used as the reference for determining the treatment time of re-anodizing treatment refers to the final thickness of the anodized film having undergone film removal treatment after re-anodizing treatment.

(3) Second Anodizing Treatment Step (Anodizing Treatment)

The first anodizing treatment step was followed by a 5-minute treatment at a temperature of 20°C in a mixed aqueous solution having a boric acid concentration of 0.5 mol/L and a sodium tetraborate concentration of 0.05 mol/L, and a voltage was set so that the thickness ($T_F$) of the portions of the anodized film where no micropore was formed may be the thickness shown in Table 3 to form an anodized film, thus preparing an insulating substrate.

The second anodizing treatment step (anodizing treatment) was not carried out in Comparative Example III-2.

The first anodizing treatment step and the second anodizing treatment step were both carried out using a stainless steel electrode as the cathode and using a GP0110-30R unit (Takasago, Ltd.) as the power supply. Use was made of NeoCool BD36 (Yamato Scientific Co., Ltd.) as the cooling system, and Pairstirrer PS-100 (Tokyo Rikakikai Co., Ltd.) as the stirring and warming unit. The flow velocity of the electrolytic solution was measured using the vortex flow monitor FLM22-10PCW (As One Corporation).

(Calculation of $T_A$, To and $T_F$)

For each of the resulting insulating substrates, the insulating substrate thickness ($T_A$), the anodized film thickness ($T_O$) and the thickness ($T_F$) of the portions of the anodized film where no micropore was formed were determined by observing from the cross-sectional direction by FE-SEM, measuring them at 10 points and calculating the average of the measurements. The results are shown in Table 3.

(Calculation of Degree of Ordering of Micropores)

A surface image (magnification: 20,000X) of each of the resulting insulating substrates was taken by FE-SEM, and the degree of ordering of 300 micropores, as defined by formula (i), was measured in a field of view of 1 $\mu$m $\times$ 1 $\mu$m. The results are shown in Table 3.

(Breakdown Voltage)

The breakdown voltage of the resulting insulating substrates was measured according to JIS C2110 standard. The results are shown in Table 3.

It can be evaluated that at a breakdown voltage of 150 or more, the insulation properties are excellent and the white light emission power can be improved.

(Thermal Conductivity)

For each of the resulting insulating substrates, TC-9000 laser flash type thermal diffusivity measuring system (ULVAC-RIKO, Inc.) was used to measure the thermal diffusivity according to the t1/2 process. The results are shown in Table 3.

It can be evaluated that at a thermal conductivity of about 200 or more, the heat dissipation properties are excellent and the white light emission power can be improved.

(Measurement of Total Reflectivity)

The total reflectivity of the resulting insulating substrates at 400 to 700 nm was measured using SP64 manufactured by X-Rite, Inc. The results are shown in Table 3.

[Table 3]

| Table 3-1 | | Example III | | | | | | |
|---|---|---|---|---|---|---|---|---|
| | | 1 | 2 | 3 | 4 | 5 | 6 | 7 |
| First anodizing treatment step | Number of repetitions | 4 | 4 | 4 | 4 | 4 | 2 | 4 |
| Shape characteristics | $T_A$ [um] | 377 | 384 | 385 | 398 | 385 | 420 | 377 |
| | $T_O$ [um] | 5 | 10 | 40 | 60 | 40 | 40 | 5 |
| | $T_A/T_O$ | 75.4 | 38.4 | 9.6 | 6.6 | 9.6 | 10.5 | 75.4 |
| | $T_F$ [nm] | 400 | 400 | 400 | 400 | 600 | 400 | 120 |
| | Degree of ordering [%] | 90 | 90 | 90 | 90 | 90 | 70 | 90 |
| Breakdown voltage [V] | | 180 | 351 | 891 | 1083 | 950 | 888 | 150 |
| Thermal conductivity [W/mK] | | 205 | 203 | 197 | 195 | 197 | 196 | 205 |
| Total reflectivity (average) [%] | 400-500nm | 86 | 84 | 84 | 82 | 83 | 81 | 85 |
| | 510-600nm | 88 | 88 | 88 | 86 | 88 | 84 | 88 |
| | 610-700nm | 89 | 88 | 88 | 86 | 85 | 84 | 89 |

[Table 4]

| Table 3-2 | | Example III | | | | | Comparative Example III | |
|---|---|---|---|---|---|---|---|---|
| | | 8 | 9 | 10 | 11 | 12 | 1 | 2 |
| First anodizing treatment step | Number of repetitions | 4 | 4 | 4 | 4 | 0 | 4 | 4 |

(continued)

| Table 3-2 | | Example III | | | | | Comparative Example III | |
|---|---|---|---|---|---|---|---|---|
| | | 8 | 9 | 10 | 11 | 12 | 1 | 2 |
| Shape characteristics | $T_A$[um] | 377 | 398 | 398 | 398 | 405 | 400 | 377 |
| | $T_O$[um] | 5 | 60 | 60 | 60 | 5 | 200 | 5 |
| | $T_A/T_O$ | 75.4 | 6.6 | 6.6 | 6.6 | 81.0 | 2.0 | 75.4 |
| | $T_F$ [nm] | 400 | 200 | 100 | 50 | 400 | 400 | 20 |
| | Degree of ordering [%] | 90 | 90 | 90 | 90 | 15 | 90 | 90 |
| Breakdown voltage [V] | | 175 | 1050 | 1020 | 960 | 182 | 1254 | 95 |
| Thermal conductivity [W/mK] | | 204 | 195 | 195 | 195 | 202 | 156 | 204 |
| Total reflectivity (average) [%] | 400-500nm | 86 | 82 | 82 | 82 | 35 | 68 | 84 |
| | 510-600nm | 89 | 86 | 86 | 86 | 42 | 70 | 88 |
| | 610-700nm | 88 | 86 | 86 | 86 | 42 | 71 | 89 |

The results shown in Table 3 revealed that the insulating substrate prepared in Comparative Example III-1 in which the ratio ($T_A/T_O$) of the thickness ($T_A$) of the insulating substrate to the thickness ($T_O$) of the anodized film was small had low thermal conductivity and poor heat dissipation properties.

It was also revealed that the insulating substrate prepared in Comparative Example III-2 in which, of the thicknesses of the anodized film in the depth direction, the thickness ($T_F$) of the portions where no micropore was formed had low breakdown voltage and poor insulation properties.

On the other hand, it was revealed that the insulating substrates prepared in Examples III-1 to III-12 in which the thickness ($T_A$), the thickness ($T_O$), the ratio ($T_A/T_O$) and the thickness ($T_F$) were all within predetermined ranges had excellent insulation properties and heat dissipation properties and could provide light-emitting devices with improved white light emission power. In particular, it was revealed that the insulating substrates prepared in Examples II-1 to II-11 showing a high degree of ordering of micropores also had a high total reflectivity and could improve the luminance of the light-emitting devices obtained. It was also revealed that the insulating substrates prepared in Examples III-3 to 6 and 9 to 11 in which the thickness ($T_O$) of the anodized film was from 20 to 70 $\mu$m and the ratio ($T_A/T_O$) of the insulating substrate thickness ($T_A$) to the anodized film thickness ($T_O$) was from 8 to 12 had extremely high insulation properties.

DESCRIPTION OF SYMBOLS

| | |
|---|---|
| 1 | insulating substrate |
| 2 | aluminum substrate |
| 3 | anodized film |
| 4 | through-hole |
| 5 | copper interconnection |
| 6 | electrode |
| 7 | conductor metal |
| 7a | remaining portion |
| 7b | unnecessary portion |
| 8 | metal foil layer |
| 9 | chip |
| 10 | joint portion |
| 11 | cutout portion |
| 12 | cut edge |
| 13 | interconnection pattern |
| 14 | anodized film |
| 15, 15a, 15b | micropores |
| 16 | different substance |

| | |
|---|---|
| 17 | insulating substrate |
| 18 | aluminum substrate |
| 19 | insulation layer |
| 20 | micropore |
| 22 | blue LED |
| 24 | resin |
| 26 | fluorescence emission unit |
| 32 | insulation layer |
| 33 | metal substrate |
| 34 | metal interconnection layer |
| 35 | through-hole |
| 37 | blue LED |
| 39 | heat sink |
| 100 | light-emitting device |
| 101, 102, 104, 105, 107, 108 | micropores |
| 103, 106, 109 | circles |
| 110 | blue LED |
| 120, 130 | metal interconnection layers (electrodes) |
| 140 | interconnection substrate |
| 150 | phosphor particle |
| 160 | transparent resin |
| 200 | light-emitting device |
| 222 | blue LED light-emitting device |
| 224 | resin |
| 226 | fluorescent emitter |
| 230 | insulating substrate |
| 232 | insulation layer |
| 233 | aluminum substrate |
| 300 | light-emitting device |
| 310 | blue LED |
| 320, 330 | electrodes |
| 340 | substrate |
| 350 | phosphor particle |
| 360 | transparent resin |
| 410 | anodizing apparatus |
| 412 | power supply cell |
| 414 | electrolytic cell |
| 416 | aluminum substrate |
| 418, 426 | electrolytic solutions |
| 420 | power supply electrode |
| 422, 428 | rollers |
| 424 | nip roller |
| 430 | electrolytic electrode |
| 432 | cell wall |
| 434 | DC power supply |

**Claims**

1. An insulating substrate comprising:

   an aluminum substrate; and
   an anodized film covering a whole surface of the aluminum substrate,
   wherein the anodized film contains intermetallic compound particles with a circle equivalent diameter of 1 $\mu$m
   or more in an amount of up to 2,000 pcs/mm$^3$.

2. The insulating substrate according to claim 1 further comprising through-holes formed so as to extend through the aluminum substrate in its thickness direction,

wherein inner wall surfaces of the through-holes are covered with the anodized film.

3. The insulating substrate according to claim 1 or 2, wherein the aluminum substrate has an aluminum purity of 99.95 wt% or more.

4. The insulating substrate according to any one of claims 1 to 3, wherein the insulating substrate is for use in an LED.

5. An insulating substrate-manufacturing method for obtaining the insulating substrate according to claim 1, comprising:

an anodizing treatment step for anodizing the aluminum substrate,
wherein the anodized film covering the whole surface of the aluminum substrate contains intermetallic compound particles with a circle equivalent diameter of 1 $\mu$m or more in an amount of up to 2,000 pcs/mm$^3$.

6. The insulating substrate-manufacturing method according to claim 5 for obtaining the insulating substrate according to claim 2, comprising, before the anodizing treatment step, a through-hole formation step for forming the through-holes in the thickness direction of the aluminum substrate.

7. The insulating substrate-manufacturing method according to claim 5 or 6, comprising, before the anodizing treatment step, an annealing treatment step for annealing the aluminum substrate at 350 to 600°C.

8. The insulating substrate-manufacturing method according to any one of claims 5 to 7, wherein a sulfuric acid electrolytic solution is used in the anodizing treatment step.

9. The insulating substrate-manufacturing method according to claim 8, wherein the sulfuric acid electrolytic solution has a sulfuric acid concentration of 10 to 60 g/l.

10. The insulating substrate-manufacturing method according to any one of claims 5 to 9, wherein the aluminum substrate has an aluminum purity of 99.95 wt% or more.

11. An interconnection-forming method for forming interconnections in desired portions on the anodized film included in the insulating substrate according to any one of claims 1 to 3, the method comprising: a supply step for selectively supplying conductor metal serving as the interconnections only to the desired portions.

12. The interconnection-forming method according to claim 11, wherein the supply step is a step for supplying metal ink containing the conductor metal to the desired portions by ink-jet printing.

13. The interconnection-forming method according to claim 11, wherein the supply step is a step for supplying metal ink containing the conductor metal to the desired portions by screen printing.

14. The interconnection-forming method according to claim 11, wherein the supply step is a step in which a treatment solution containing ions of the conductor metal is used to perform electroless plating and/or electrolytic plating on the insulating substrate having a resist formed in portions other than the desired portions on the anodized film.

15. The interconnection-forming method according to claim 11, wherein the supply step is a step including forming a metal-reducing layer having metal-reducing ability in the desired portions and bringing the formed metal-reducing layer into contact with a treatment solution containing ions of the conductor metal.

16. The interconnection-forming method according to any one of claims 11 to 15, wherein the desired portions are located on front and back sides of the insulating substrate.

17. An insulating substrate comprising:

a metal substrate and an insulation layer formed at a surface of the metal substrate,
wherein the metal substrate is a valve metal substrate,
wherein the insulation layer comprises an anodized film of a valve metal, and
wherein the anodized film has a porosity of 30% or less.

18. The insulating substrate according to claim 17, wherein the anodized film has surface topographic features with an average diameter of at least 1 μm at an average pitch of up to 0.5 μm.

19. The insulating substrate according to claim 17 or 18,

wherein the anodized film has micropores, and
wherein at least part of an interior of each of the micropores is sealed with a different substance from a substance making up the anodized film.

20. The insulating substrate according to any one of claims 17 to 19,
wherein the anodized film has micropores, and
wherein the micropores include micropores each having an interior at least partly sealed with a different substance from a substance making up the anodized film, and micropores each having an interior unsealed with the different substance.

21. The insulating substrate according to claim 19 or 20, wherein the different substance has insulation properties.

22. The insulating substrate according to any one of claims 17 to 21, wherein the valve metal is at least one metal selected from the group consisting of aluminum, tantalum, niobium, titanium, hafnium, zirconium, zinc, tungsten, bismuth and antimony.

23. The insulating substrate according to claim 22, wherein the valve metal is aluminum.

24. The insulating substrate according to any one of claims 17 to 23, wherein the insulating substrate is a substrate provided on a light emission observation surface side of an LED light-emitting device.

25. An insulating substrate-manufacturing method for manufacturing the insulating substrate according to any one of claims 17 to 24, the method comprising:

an anodizing treatment step for anodizing a surface of the valve metal substrate to form the anodized film of the valve metal on the valve metal substrate; and
a sealing treatment step for sealing after the anodizing treatment step to adjust the porosity of the anodized film to 30% or less.

26. The insulating substrate-manufacturing method according to claim 25,
wherein the anodized film having the micropores is formed by the anodizing treatment, and
wherein at least part of the interior of each of the micropores is sealed with the different substance from the substance making up the anodized film by the sealing treatment.

27. The insulating substrate-manufacturing method according to claim 25 or 26, comprising a through-hole formation step for forming through-holes in a thickness direction of the valve metal substrate.

28. The insulating substrate-manufacturing method according to claim 27, comprising, after the through-hole formation step, a chip formation step for enabling the valve metal substrate to be divided into individual chips having a desired shape.

29. An interconnection substrate comprising: the insulating substrate according to any one of claims 17 to 24 and a metal interconnection layer provided on top of the insulating substrate on an insulation layer side.

30. A white LED light-emitting device comprising: the interconnection substrate according to claim 29; a blue LED light-emitting device provided on top of the interconnection substrate on a metal interconnection layer side; and a fluorescent emitter provided at least on top of the blue LED light-emitting device.

31. An insulating substrate comprising:

an aluminum substrate and an insulation layer formed at a surface of the aluminum substrate,
wherein the insulation layer comprises an aluminum anodized film having micropores,
wherein the insulating substrate has a thickness of up to 1,500 μm,
wherein the anodized film has a thickness of at least 5 μm,

wherein a ratio $(T_A/T_O)$ of the thickness $(T_A)$ of the insulating substrate to the thickness $(T_O)$ of the anodized film is from 2.5 to 300, and

wherein, of thicknesses of the anodized film in its depth direction, a thickness of a portion where no micropore is formed is at least 30 nm.

**32.** The insulating substrate according to claim 31, wherein a degree of ordering of the micropores as defined by formula (i):

$$\text{Degree of ordering (\%)} = B/A \times 100 \quad (i)$$

(in formula (i), A represents a total number of micropores in a measurement region, and B represents a number of specific micropores in the measurement region for which, when a circle is drawn so as to be centered on a center of gravity of a specific micropore and so as to be of a smallest radius that is internally tangent to an edge of another micropore, the circle includes centers of gravity of six micropores other than the specific micropore) is 20% or more.

**33.** The insulating substrate according to claim 31 or 32,
wherein the insulating substrate is a substrate provided on a light emission observation surface side of an LED light-emitting device.

**34.** An insulating substrate-manufacturing method for manufacturing the insulating substrate according to any one of claims 31 to 33, the method comprising:

a first anodizing treatment step for anodizing part of the aluminum substrate to form the aluminum anodized film having the micropores on the aluminum substrate; and
a second anodizing treatment step which follows the first anodizing treatment step and in which an electrolytic solution at a pH of 2.5 to 11.5 is used to carry out anodizing treatment to seal part of an interior of each of the micropores with aluminum oxide from a bottom direction.

**35.** A white LED light-emitting device comprising: the insulating substrate according to any one of claims 31 to 33; a blue LED light-emitting device provided on top of the insulating substrate on an insulation layer side; and a fluorescent emitter provided at least on top of the blue LED light-emitting device.

# FIG. 1

(A)

(B)

2  3

# FIG. 2

| ANNEALING TREATMENT |
| THROUGH-HOLE FORMATION |
| CHIP FORMATION |
| ETCHING |
| RINSING WITH WATER |
| ANODIZING TREATMENT |

# FIG. 3

(A)

(B)

# FIG. 4

(A)

(B)

# FIG. 5

(A1)

(A2)

(A3)

(A4)

ROUTING

ANODIZING TREATMENT

# FIG. 6

(B1)

9   10   9

ANODIZING TREATMENT

(B2)

10

3   1

CHIP FORMATION

(B3)

9   3

# FIG. 7

(C1) 10     10     9

ANODIZING
TREATMENT

(C2) 3     3   10

2     1

CHIP
FORMATION

(C3)     12

9   3

# FIG. 8

(A)

(B)

# FIG. 9

(A)

(B)

(C)

(D)

# FIG. 10

(A)

13

0.2mm φ

4

1mm

1.5mm

1

(B)

13

4

4mm

1

# FIG. 11

(A)

(B)

# FIG. 12

# FIG. 13

# FIG. 14

# FIG. 15

# FIG. 16

# FIG. 17

(A)

103

102 101

(B)

108 107 109

106 104 105

# FIG. 18

# FIG. 19

# FIG. 20

<table>
<tr><td colspan="2" align="center">**INTERNATIONAL SEARCH REPORT**</td><td>International application No.<br>PCT/JP2010/072463</td></tr>
</table>

| A. CLASSIFICATION OF SUBJECT MATTER |
| --- |
| *C25D11/04*(2006.01)i, *H01L33/62*(2010.01)i |
| According to International Patent Classification (IPC) or to both national classification and IPC |

| B. FIELDS SEARCHED |
| --- |
| Minimum documentation searched (classification system followed by classification symbols)<br>C25D11/04, H01L33/62 |
| Documentation searched other than minimum documentation to the extent that such documents are included in the fields searched<br>Jitsuyo Shinan Koho    1922-1996  Jitsuyo Shinan Toroku Koho  1996-2011<br>Kokai Jitsuyo Shinan Koho  1971-2011  Toroku Jitsuyo Shinan Koho  1994-2011 |
| Electronic data base consulted during the international search (name of data base and, where practicable, search terms used) |

| C. DOCUMENTS CONSIDERED TO BE RELEVANT |||
| --- | --- | --- |
| Category* | Citation of document, with indication, where appropriate, of the relevant passages | Relevant to claim No. |
| A | JP 59-107592 A (TDK Corp.),<br>21 June 1984 (21.06.1984),<br>(Family: none) | 1-30 |
| A | JP 5-304346 A (Sky Aluminium Co., Ltd.),<br>16 November 1993 (16.11.1993),<br>(Family: none) | 1-30 |
| A | JP 3031363 B1 (Sumitomo Metal Industries, Ltd.),<br>10 April 2000 (10.04.2000),<br>& JP 2000-124568 A | 1-30 |
| A | JP 2000-150718 A (Sumitomo Metal Industries, Ltd.),<br>30 May 2000 (30.05.2000),<br>(Family: none) | 1-30 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>14 March, 2011 (14.03.11) | Date of mailing of the international search report<br>22 March, 2011 (22.03.11) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/072463

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2000-349320 A  (Kobe Steel, Ltd.),<br>15 December 2000 (15.12.2000),<br>(Family: none) | 1-30 |
| A | JP 2003-272960 A  (Mitsubishi Aluminum Co., Ltd.),<br>26 September 2003 (26.09.2003),<br>(Family: none) | 1-30 |

Form PCT/ISA/210 (continuation of second sheet) (July 2009)

**EP 2 518 190 A1**

**INTERNATIONAL SEARCH REPORT**

International application No.

PCT/JP2010/072463

---

**Box No. II**     **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III**     **Observations where unity of invention is lacking (Continuation of item 3 of first sheet)**

This International Searching Authority found multiple inventions in this international application, as follows:

    The technical feature common to the inventions in claims 1 - 30 and the
   inventions in claims 31 - 35 is not a special technical feature in the light
   of the contents of the prior art.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1 - 30

**Remark on Protest**     ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007250315 A
- JP 55154564 U
- JP 2006344978 A
- JP 7014938 A
- JP 2006244828 A
- JP 2009164583 A
- JP 11504387 A
- JP 6045515 A
- JP 2998696 B
- JP 11087784 A
- JP 59153861 A
- JP 61051395 A
- JP 62146694 A
- JP 60215725 A
- JP 60215726 A
- JP 60215727 A
- JP 60216728 A
- JP 61272367 A
- JP 58011759 A
- JP 58042493 A
- JP 58221254 A
- JP 62148295 A
- JP 4254545 A
- JP 4165041 A
- JP 3068939 B
- JP 3234594 A
- JP 1047545 B
- JP 62140894 A
- JP 1035910 B
- JP 55028874 B
- JP 7081264 A
- JP 7305133 A
- JP 8049034 A
- JP 8073974 A
- JP 8108659 A
- JP 8092679 A
- JP 62005080 B
- JP 63060823 B
- JP 3061753 B
- JP 60203496 A
- JP 60203497 A
- JP 3011635 B
- JP 61274993 A
- JP 62023794 A
- JP 63047347 A
- JP 63047348 A
- JP 63047349 A
- JP 64001293 A
- JP 63135294 A
- JP 63087288 A
- JP 4073392 B
- JP 7100844 B
- JP 62149856 A
- JP 4073394 B
- JP 62181191 A
- JP 5076530 B
- JP 63030294 A
- JP 6037116 B
- JP 2215599 A
- JP 61201747 A
- JP 60230951 A
- JP 1306288 A
- JP 2293189 A
- JP 54042284 B
- JP 4019290 B
- JP 4019291 B
- JP 4019292 B
- JP 61035995 A
- JP 6451992 A
- JP 4226394 A
- US 5009722 A
- US 5028276 A
- JP 62086143 A
- JP 3222796 A
- JP 63060824 B
- JP 60063346 A
- JP 60063347 A
- JP 1293350 A
- EP 223737 B
- US 4818300 A
- GB 1222777 A
- JP 63015978 B
- JP 63143234 A
- JP 63143235 A
- GB 1421710 A
- JP 6057432 A
- JP 3162530 A
- JP 5140659 A
- JP 4231425 A
- JP 4276031 A
- JP 5311261 A
- JP 6136466 A
- JP 5051659 A
- JP 5049148 U
- JP 7040017 A
- JP 3079798 A
- JP 5201166 A
- JP 6262203 A

- JP 6122949 A
- JP 6210406 A
- JP 6220593 A
- JP 6210308 A
- JP 7054111 A
- JP 8092709 A
- JP 6218495 A
- JP 7039906 A
- JP 7124609 A
- JP 6048058 A
- JP 5301478 A
- JP 7132689 A
- JP 7138687 A
- JP 2007245116 A
- JP 54081133 A
- JP 57047894 A
- JP 57051289 A
- JP 57051290 A
- JP 57054300 A
- JP 57136596 A
- JP 58107498 A
- JP 60200256 A
- JP 62136596 A
- JP 63176494 A
- JP 4176897 A
- JP 4280997 A
- JP 6207299 A
- JP 5024377 A
- JP 5032083 A
- JP 5125597 A
- JP 5195291 A

- JP 54012853 A
- JP 48045303 A
- JP 48026638 A
- JP 47018739 A
- JP 58024517 B
- JP 3714507 B
- JP 2002285382 A
- JP 2006 A
- JP 124827 A
- JP 2007231339 A
- JP 2007231405 A
- JP 2007231340 A
- JP 2007238988 A
- JP 56012518 B
- JP 4004194 A
- JP 5202496 A
- JP 5179482 A
- JP 6035174 A
- JP 2008093652 A
- JP 2009068076 A
- JP 2009134007 A
- JP 2009139261 A
- US 2708655 A
- JP 2006124827 A
- JP 2008063643 A
- JP 2008156705 A
- JP 10121292 A
- JP 2001105400 A
- JP 2003129288 A
- JP 2008156716 A

**Non-patent literature cited in the description**

- **WERNER STOBER et al.** *J. Colloid and Interface Sci.,* 1968, vol. 26, 62-69
- **RICKEY D.BADLEY et al.** *Lang muir,* 1990, vol. 6, 792-801
- *Shikizai Kyokai-shi,* 1988, vol. 61 (9), 488-493
- Yokyoku Sanka. 1969, 195-207

- Shin Arumaito Riron. Kallos Publishing Co., Ltd, 1997, 95-96
- Aluminum Handbook. 2001, 164-165
- *Jitsumu Hyomen Gijutsu,* 1986, vol. 33 (3), 32-38